(19) Europäisches Patentamt
European Patent Office
Office européen des brevets

(11) **EP 3 371 836 B1**

(12) **EUROPÄISCHE PATENTSCHRIFT**

(45) Veröffentlichungstag und Bekanntmachung des Hinweises auf die Patenterteilung:
**06.11.2019   Patentblatt 2019/45**

(21) Anmeldenummer: **16788508.6**

(22) Anmeldetag: **28.10.2016**

(51) Int Cl.:
*H01L 43/08* *(2006.01)*       *H01L 43/10* *(2006.01)*
*H01L 29/66* *(2006.01)*

(86) Internationale Anmeldenummer:
**PCT/EP2016/076041**

(87) Internationale Veröffentlichungsnummer:
**WO 2017/076763 (11.05.2017 Gazette 2017/19)**

(54) **MAGNETISCHE TUNNELDIODE UND MAGNETISCHER TUNNELTRANSISTOR**

MAGNETIC TUNNEL DIODE AND MAGNETIC TUNNEL TRANSISTOR

DIODE TUNNEL MAGNÉTIQUE ET TRANSISTOR TUNNEL MAGNÉTIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.11.2015   DE 102015221521**

(43) Veröffentlichungstag der Anmeldung:
**12.09.2018   Patentblatt 2018/37**

(73) Patentinhaber: **Forschungszentrum Jülich GmbH**
**52428 Jülich (DE)**

(72) Erfinder:
• **SASIOGLU, Ersoy**
**38226 Salgitter (DE)**
• **BLÜGEL, Stefan**
**52072 Aachen (DE)**

(74) Vertreter: **Gille Hrabal**
**Brucknerstrasse 20**
**40593 Düsseldorf (DE)**

(56) Entgegenhaltungen:
**EP-A1- 1 548 832     US-A1- 2008 246 023**

• **SAITO H ET AL: "Spin-polarized tunneling in fully epitaxial magnetic tunnel diodes with a narrow-gap In1-xMnxAs electrode", APPLIED PHYSICS LETTERS, Bd. 95, Nr. 19, 192508, 13. November 2009 (2009-11-13), XP012126433, ISSN: 0003-6951, DOI: 10.1063/1.3264962**

**Beschreibung**

Die Erfindung betrifft eine magnetische Tunneldiode und einen magnetischen Tunneltransistor sowie entsprechende Verfahren zu deren Verwendung.

Quantentunneldioden und Quantentunneltransistoren, insbesondere Hot-Carrier-Dioden und Hot-Carrier-Transistoren, werden als einige der aussichtsreichsten Kandidaten für Hochgeschwindigkeitselektronikgeräte angesehen. Betriebsfrequenzen von bis zu 30 THz in Metall-Isolator-Metall-Tunneldioden und mehrere Graphen-basierte vertikale Quantentunneltransistoren wurden bereits experimentell realisiert. Zu beachten ist dabei, dass Quantentunneltransistoren ein großes Potenzial für hochfrequente, dicht gepackte Hochgeschwindigkeits-ICs - integrierte Schaltkreise - besitzen.

Die zusätzliche Ausnutzung des intrinsischen magnetischen Spinmoments der Elektronen neben der elektrischen Ladung hat zur Entwicklung eines neuen Forschungsbereichs, der Spintronik oder Spinelektronik, geführt, das zusätzliche Funktionalitäten wie Nichtflüchtigkeit, Rekonfigurierbarkeit etc. bietet. Die Entdeckung des Riesenmagnetowiderstands in Spin-Ventilen und des Tunnelmagnetowiderstand-Effekts in magnetischen Tunnelkontakten inspirierte zahlreiche Sensor- und Speicher-Anwendungen.

Tunnelmagnetowiderstand oder magnetischer Tunnelwiderstand (TMR, engl. tunnel magnetoresistance) ist ein magnetoresistiver Effekt, der in magnetischen Tunnelkontakten (engl. magnetic tunnel junction) auftritt. Dabei handelt es sich in der Regel um ein Bauelement bestehend aus zwei Ferromagneten, die durch einen dünnen Isolator getrennt sind. Ist die isolierende Schicht dünn genug, typisch einige Nanometer, so können Elektronen zwischen den beiden Ferromagneten tunneln. Mithilfe eines äußeren Magnetfeldes kann die Richtung der Magnetisierung der beiden magnetischen Schichten unabhängig voneinander gesteuert werden. Wenn die Magnetisierungen gleich ausgerichtet sind, ist die Wahrscheinlichkeit, dass Elektronen durch die Isolatorschicht hindurchtunneln, größer als bei gegensätzlicher, also antiparalleler, Ausrichtung. Damit kann der elektrische Widerstand des Kontakts zwischen zwei unterschiedlichen Widerstandszuständen - binär also 0 und 1 - hin und her geschaltet werden.

Die großen Magnetowiderstände, die in diesen Bauteilen erzielt werden, motivierten den hohen Forschungsaufwand für die Entwicklung einer Vielzahl spintronischer Bauteile, darunter magnetische Tunneldioden, magnetischen RAM, magnetische Tunneltransistoren, Spin-Feldeffekttransistoren usw. Diodeneffekt und Magnetowiderstand wurden bereits bei einzelnen asymmetrischen magnetischen Tunnelbarrieren beobachtet, jedoch mit geringem Rektifizierungsverhältnis.

Andererseits erwartet man von einem doppelten Tunnelkontakt mit zwei Tunnelbarrieren unterschiedlicher Transparenz eine hoch asymmetrische Leitfähigkeit, je nach Richtung der Polarität, d. h. er fungiert als Diode oder Stromgleichrichter. Ein solcher Diodeneffekt wurde bei doppelten Tunnelkontakten bereits beobachtet, jedoch mit verschwindend geringem Magnetowiderstand. Ebenso ist ein starker Diodeneffekt und ein hoher Magnetowiderstand in asymmetrischen doppelten Metall/Oxid-Tunnelkontakten bekannt.

Um bei magnetischen Tunneldioden asymmetrische Strom-Spannungs-(I-V)-Eigenschaften zu erzielen, sind zwei Tunnelbarrieren unterschiedlicher Höhe notwendig. Dies führt jedoch zu hohen Schwellenspannungen $V_{th}$ und begrenzten Strömen. Durch diese Hauptnachteile magnetischer Tunneldioden sind diese für den Einsatz als Bauelemente mit niedriger Leistung ungeeignet.

Magnetische Tunneldioden sind mit zwei Anschlüssen ausgestattete Bauelemente, die die Bausteine für die mit drei Anschlüssen ausgestatteten magnetischen Tunneltransistoren darstellen. Diese basieren entweder auf Metall-Isolator-Metall-Halbleiter- oder auf Metall-Isolator-Metall-Isolator-Metall-Strukturen. Die Funktionsprinzipien der Bauteile sind ähnlich, und unterscheiden sich, je nachdem welche Art Barriere verwendet wird, nur in den Kollektor-Mechanismen.

Die Transferrate a, die als Verhältnis zwischen Kollektor- und Emitter-Strom ($I_c/I_e$) definiert ist, stellt eine wichtige Kennzahl für die Leistungsbewertung von magnetischen Tunneltransistoren dar. Magnetische Tunneltransistoren mit niedrigerer Transferrate $\alpha$ und geringem Magnetstrom-Verhältnis sind bekannt. Jedoch wurden in neueren Experimenten mit voll-epitaktischen magnetische Tunneltransistoren mäßige Transferraten $\alpha$ und Magnetstrom-Verhältnisse festgestellt. Dies wurde auf kohärentes Tunneln und die einkristalline Grundschicht zurückgeführt (T. Nagahama et al., Appl. Phys. Lett. 96, 112509, 2010). Durch die hohen Basis-Kollektor-Leckströme und ungenügenden Transferraten sind diese magnetischen Tunneltransistoren für den Einsatz als Bauelemente ungeeignet.

Konventionelle Hot-Carrier-Tunneltransistoren und andere magnetische und nichtmagnetischen Tunneltransistoren weisen in der Regel nachteilhaft niedrige Transferraten $\alpha$ infolge dicker Tunnelbarrieren und hohe Betriebsspannungen auf, wobei ein reduzieren der Tunnelbarrierendicke zu erhöhten Leckströmen führen würde.

Magnetische Tunneldioden und -transistoren besitzen außerdem zusätzliche Funktionalitäten gegenüber ihren Ladung-basierten Gegenstücken, darunter die Verwendung magnetischer Elektroden: Sie ermöglicht die Steuerung und nichtflüchtige Programmierung der Strom-Spannungs-(I-V)-Eigenschaften. Trotz dieser Funktionalität können diese Bauelemente nicht dynamisch rekonfiguriert werden. Das bedeutet, dass die Rektifizierungseigenschaften von magnetischen Tunneldioden und asymmetrischen Strom-Spannungseigenschaften von magnetischen Tunneltransistoren nach der Herstellung nicht mehr verändert werden können.

Eine magnetische Tunneldiode lässt Strom in einer Richtung passieren, nicht aber in der anderen. In Hinblick darauf wurde unlängst experimentell ein Ladung-basierter rekonfigurierbarer Metall-Silikon-Metall-Nanodrahttransistor realisiert (H. Yan et al., Nature 470, 240, 2011). Dieser neue Transistor ist ein mit vier Anschlüssen ausgestattetes Bauelement und verbindet die elektrischen Eigenschaften unipolarer n- und p-Feldeffekttransistoren (FETs) in einem einzigen Bauelement. Er kann dynamisch rekonfiguriert werden, und so als p- oder n-FET betrieben werden, je nach Programmierung anhand eines elektrischen Signals durch den Programmanschluss (engl. control gate). Neben den Transistor-Funktionalitäten des Bauelements kann es ebenfalls als rekonfigurierbare Diode verwendet werden, indem an Steueranschluss und Programmanschluss Spannung mit jeweils verschiedenem Vorzeichen angelegt wird. Jedoch besteht ein großer Nachteil dieses rekonfigurierbaren, mit vier Anschlüssen ausgestatteten Transistors bzw. Diode im zusätzlichen Programmanschluss bzw. -anschlüssen, der die Komplexität des Bauelements erhöht und damit die Skalierbarkeit einschränkt. Ihm fehlt außerdem die nichtflüchtige Funktionalität von magnetischen Tunneltransistors bzw. der magnetischen Tunneldiode, da es sich um einen Ladung-basierten Transistor bzw. Diode handelt. Zudem führt die erhöhte Anzahl von Anschlüssen zu höheren Leckströmen und damit erhöhtem Stromverbrauch.

Ein Spin-Transistor ist aus der Druckschrift US 8269293 B2 bekannt. Die Druckschrift US 7259437 B2 offenbart einen Hochleistungs-Spin-Ventil-Transistor. Ein Magnettunneltransistor ist aus der Druckschrift US 8233249 B2 bekannt. Die Druckschrift US 2004/0207961 A1 offenbart ein Magnetwiderstandsgerät und ferromagnetische Schichten, die keinen Halbleiter ohne Spin-Anregungslücke umfassen.

EP 1 548 832 A1 offenbart eine TMR p-i-n Diode mit einer Tunnelbarriere zwischen zwei halbmetallischen Ferromagnet-Halbleiterschichten, beispielsweise Mn-dotiertes GaN und Cr-dotiertes GaN, sowie die Umkehrung der Magnetisierung einer Halbleiterschicht mittels Stromdurchgang oder externem Magnetfeld und die Verwendung derselben zur Erzielung der Nichtflüchtigkeit (MRAM) und des Tunnelmagnetowiderstandseffekts (TMR).

US 2008/246023 A1 offenbart einen magnetischen Tunneltransistoren mit drei Anschlüssen umfassend einen Emitter, eine Emitter-Basis-Tunnelbarriere, eine Basis, eine Basis-Kollektor-Tunnelbarriere und einen Kollektor, wobei Emitter, Basis und Kollektor aus einer Halbmetall- oder halbleitenden Magnetschicht bestehen können.

Die oben beschriebenen Probleme und die mangelnde Kombinierbarkeit der Eigenschaften Nichtflüchtigkeit und Rekonfigurierbarkeit von Tunneldioden und Tunneltransistoren begrenzen daher die technologische Weiterentwicklung nanoelektronischer Bauelemente.

Die vorgenannten, aus dem Stand der Technik bekannten Merkmale können einzeln oder in beliebiger Kombination mit einem der nachfolgend beschriebenen erfindungsgemäßen Gegenstände kombiniert werden.

Es ist daher Aufgabe der Erfindung, eine entsprechend weiterentwickelte magnetische Tunneldiode und einen magnetischen Tunneltransistor nebst Verfahren zur Konfigurierung bereitzustellen.

Die Aufgabe wird gelöst durch den Gegenstand der unabhängigen Ansprüche 1, 10, 12-14.

Zur Lösung der Aufgabe dienen eine magnetische Tunneldiode gemäß Anspruch 1 und ein magnetischer Tunneltransistor gemäß Anspruch 10 sowie Verfahren nach den Ansprüchen 12-14. Vorteilhafte Ausführungsformen ergeben sich aus den Unteransprüchen.

Zur Lösung der Aufgabe dient eine magnetische Tunneldiode mit zwei Anschlüssen, insbesondere mit genau zwei Anschlüssen, zum Verbinden mit einem Stromkreis sowie einem Tunnelkontakt mit einer Materialschicht aus einem halbmetallischen Magneten, einer Tunnelbarriere und einer Materialschicht aus einem Halbleiter ohne Spin-Anregungslücke. Materialschicht "aus" meint Materialschicht "umfassend" oder "bestehend aus".

Mit Magnet oder magnetisch ist in dieser Anmeldung sowohl ein dauermagnetisches Material ebenso wie ein ferromagnetisches oder ferrimagnetisches Material gemeint. Dies umfasst ebenfalls z.B. einen Ferromagneten in einem Zustand ohne Magnetwirkung aufgrund der Abwesenheit eines externen Magnetfeldes.

Halbmetallischer Magnet kann gelesen werden als ein halbmetallischer, magnetischer Werkstoff.

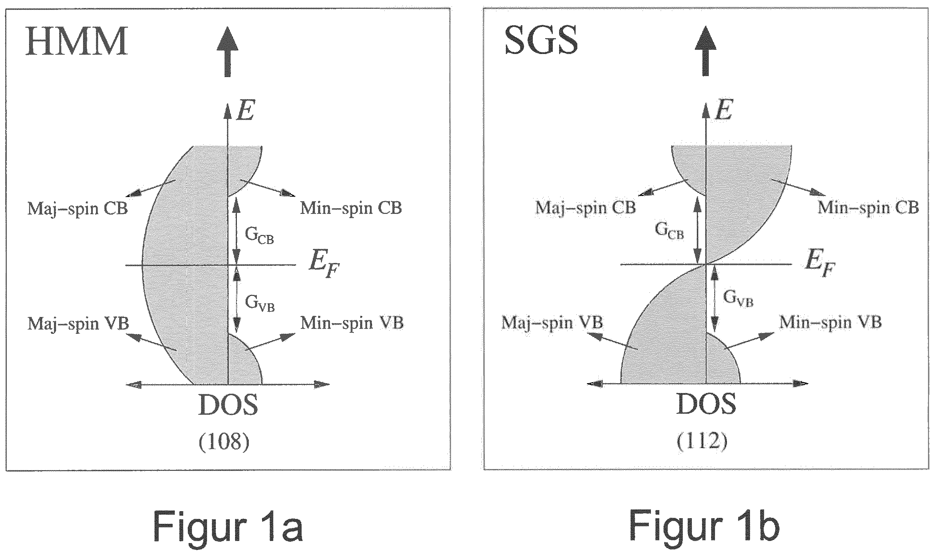

Halbleiter ohne Spin-Anregungslücke kann gelesen werden als ein Werkstoff oder Material mit Halbleitereigenschaften oder ein Halbleitermaterial, welches keine Spin-Anregungslücke zwischen dem Valenzband und Leitungsband aufweist, wobei keine Spin-Anregungslücke auch dann vorliegt, wenn im Bereich der Fermienergie ein Majoritäts-Spin-Valenzband in ein Minoritäts-Spin-Leitungsband oder ein Minoritäts-Spin-Valenzband in ein Majoritäts-Spin-Leitungsband übergeht (siehe Fig. 1b). Bei einem Halbleiter ohne Spin-Anregungslücke gibt es eine Bandlücke der Majoritäts-Spin-Elektronen über der Fermienergie und eine Bandlücke der Minoritäts-Spin-Elektronen unterhalb der Fermienergie - oder umgekehrt. Ein Halbleitermaterial ohne Spin-Anregungslücke ist beispielsweise in der Druckschrift US 20110042712 A1 beschrieben. Demgegenüber liegt eine Anregungslücke vor, wenn entweder zwischen dem Majoritäts-Spin-Valenzband und dem Majoritäts-Spin-Leitungsband und/oder dem Minoritäts-Spin-Valenzband und dem Minoritäts-Spin-Leitungsband eine Anregungslücke vorliegt (siehe Fig. 1a).

Ein weiterer Aspekt der Erfindung betrifft einen magnetischen Tunneltransistor mit drei Anschlüssen, insbesondere mit genau drei Anschlüssen, zum Verbinden mit einem Stromkreis sowie einer Schichtanordnung, insbesondere umfassend den Tunnelkontakt der zuvor beschriebenen magnetischen Tunneldiode, umfassend eine Emitter-Halbmetall-Magnetschicht, eine Emitter-Basis-Tunnelbarriere, eine Halbleiterschicht ohne Spin-Anregungslücke, einer Basis-Kollektor-Tunnelbarriere und einer Kollektor-Halbmetall-Magnetschicht.

Mit der erfindungsgemäßen magnetischen Tunneldiode und dem erfindungsgemäßen magnetischen Tunneltransistor können durch die Verwendung eines halbmetallischen Magnetmaterials und einem Halbleitermaterial ohne Spin-Anregungslücke die beide Eigenschaften Nichtflüchtigkeit und Rekonfigurierbarkeit erzielt werden.

Nichtflüchtigkeit bedeutet, dass Eingangs- und Ausgangssignalinformationen bei Abschalten des Stroms nicht verloren gehen, wodurch beispielsweise Anwendungen im Bereich von Speichermedien ermöglicht werden.

Rekonfigurierbar bedeutet, dass die Ausgangssignalfunktion spontan auch während des Betriebs definiert werden kann, wodurch beispielsweise Anwendungen im Bereich von Computerprozessoren ermöglicht werden.

Auf rekonfigurierbaren magnetischen Tunneldioden und -transistoren basierende Bauelemente ermöglichen viele Vorteile, darunter eine hohe Betriebsgeschwindigkeit (im THz-Bereich), einen geringen Energieverbrauch, einfache Schaltkreis-Strukturen usw. Z.B. könnte ein Bauelement, das während der Verwendung durch Senden von Anweisungen an jeden Anschluss gesteuert wird, Programm-spezifisch rekonfiguriert werden.

Der zusätzliche Vorteil der Nichtflüchtigkeit ermöglicht die Kombination von Logik- und Speicherfunktionen auf einem einzigen Chip und kann so die Verwendung eines externen Speichers grundsätzlich überflüssig machen.

Durch den Einsatz einer halbmetallischen Magnetschicht (HMM) und einer durch eine Tunnelbarriere davon getrennten Halbleitermaterialschicht ohne Spin-Anregungslücke (SGS) kann eine verbessert asymmetrische Strom-Spannungs-(I-V)-Eigenschaft erzielt werden, d.h. eine noch asymmetrischere Strom-Spannungskennlinie und eine Schwellenspannung $V_{th}$ kann durch Verändern der Dicke und Höhe der Tunnelbarriere besonders einfach eingestellt werden.

Zudem kann so ein großer Stromfluss verglichen mit konventionellen Tunneldioden ermöglicht werden, was den Einsatz als Bauelemente mit niedriger Leistung eröffnet.

Durch den Einsatz des Halbleitermaterials ohne Spin-Anlegungslücke in einer Tunneldiode oder einem Tunneltransistor können ferner Bauteile mit niedriger Leistung unter Hochgeschwindigkeit oder Hochfrequenz ermöglicht werden, bei denen insbesondere der erzielbare TMR-Effekt zur Realisierung magnetisch-logischer Anwendungen vorteilhaft zum Tragen kommen kann. Denn alle logischen Funktionen können so durch nur zwei magnetische Tunneldioden durch den inversen TMR-Effekt implementiert werden. Bestehende Tunnelkontakte sind durch die hohe Spannungsabhängigkeit und geringe TMR-Werte in der Regel ungeeignet für eine wirtschaftliche Implementierung in einem Gerät. Dabei ist anzumerken, dass nicht alle logischen Funktionen durch Dioden-Logik alleine realisiert werden können und nur die nicht-invertierte logischen "und"- und "oder"-Funktionen durch Halbleiterdiodengates implementiert werden können. Um alle logischen Gates zu realisieren wären etwa zwanzig konventionelle Metall-Oxid-Halbleiter-Feldeffekttransistoren (MOSFET), demgegenüber jedoch nur zwei erfindungsgemäße magnetische Tunneldioden notwendig. Ein reduzierter Herstellungsaufwand entsprechender Geräte und Einsparungen von Wafern kann so ermöglicht werden.

Zudem sind integrierter Logikgatterschaltung auf Halbleiterbasis nach der Herstellung üblicherweise nicht mehr rekonfigurierbar und zudem regelmäßig flüchtig, weil Inputs und Outputs die Informationen nach einer Unterbrechung der Energiezufuhr verloren gehen. Demgegenüber sind logische Gates, also Logikgatter, bei Verwendung der erfindungsgemäßen magnetischen Tunneldioden nicht-flüchtig und können somit unabhängig von der Energiezufuhr Informationen speichern. Zudem wird eine Rekonfigurierbarkeit auch nach der Herstellung ermöglicht, d.h. die Ausgangsfunktion kann ständig auch während des laufenden Betriebs neu definiert werden. Schließlich wird es ermöglicht, einige Teile als logischer Schaltkreis und andere als Speicher zu benutzen.

Der erfindungsgemäße magnetische Tunneltransistor hat symmetrische Transistorfunktionen vergleichbar mit konventionellen Metall-Oxid-Halbleiter-Feldeffekttransistoren (MOSFET). Allerdings weist der erfindungsgemäße magnetische Tunneltransistor gegenüber einem MOSFET die Vorteile der Nichtflüchtigkeit und Rekonfigurierbarkeit auf und kann zudem auch bei hohen Frequenzen betrieben werden bis in den THz-Bereich, wobei gleichzeitig ein geringerer Energieverbrauch anfällt.

Bauteile auf Basis der erfindungsgemäßen magnetischen Tunneldioden und Tunneltransistoren ermöglichen hohe Betriebsfrequenzen, geringen Energieverbrauch und einfache Schaltungsstrukturen, so dass z.B. ein Logikbaustein durch Senden von Befehlen gesteuert werden kann, um etwa einen Gate umzustellen, während der Baustein im Betrieb programspezifische Rekonfigurationen umsetzten kann.

Durch die Nichtflüchtigkeit und Rekonfigurierbarkeit wird ermöglicht, dass Logik und Speicher auf demselben Chip kombiniert werden kann und somit externe Speicher überflüssig werden.

In einer Ausführungsform der erfindungsgemäßen magnetischen Tunneldiode weist die Materialschicht aus dem halbmetallischen Magneten eine fixierte - also festgelegte oder festgestellte - Magnetisierungsrichtung und die Materialschicht aus dem Halbleiter ohne Spin-Anregungslücke eine rekonfigurierbare Magnetisierungsrichtung auf. Bei der erfindungsgemäßen magnetischen Tunneldiode ist jedoch auch der umgekehrte Fall möglich, nämlich, dass die Materialschicht aus dem halbmetallischen Magneten eine rekonfigurierbare Magnetisierungsrichtung und die Materialschicht aus dem Halbleiter ohne Spin-Anregungslücke eine fixierte Magnetisierungsrichtung aufweist.

Eine besonders einfache Rekonfigurierbarkeit sowie ein flexibler Einsatz der Tunneldiode kann so ermöglicht werden.

In einer Ausführungsform der erfindungsgemäßen magnetischen Tunneldiode ist eine an den Tunnelkontakt - also entweder an die Materialschicht aus dem halbmetallischen Magneten oder die Materialschicht aus dem Halbleiter ohne Spin-Anregungslücke - angrenzende Feststellschicht zum Fixieren der Magnetisierungsrichtung entweder der Materialschicht aus dem halbmetallischen Magneten bei einem Angrenzen der Feststellschicht an dem halbmetallischen Magneten oder der Materialschicht aus dem Halbleiter ohne Spin-Anregungslücke bei einem Angrenzen der Feststellschicht an dem Halbleiter ohne Spin-Anregungslücke vorgesehen. Ein zuverlässiges Fixieren der Magnetisierungsrichtung kann so erzielt werden.

In einer Ausführungsform der erfindungsgemäßen magnetischen Tunneldiode ist eine Schichtdicke der Materialschicht aus dem Halbleiter ohne Spin-Anregungslücke von mindestens 1 nm, bevorzugt 2 nm, und/oder höchstens 40 nm, vorzugsweise höchstens 20 nm, besonders bevorzugt höchstens 8 nm, vorgesehen.

Eine zuverlässige Diodenfunktion und auch Transistorfunktion bei Integration der Diode in einen Transistor kann so ermöglicht werden und zugleich eine reproduzierbare Herstellbarkeit gewährleistet werden.

In einer Ausführungsform des erfindungsgemäßen magnetischen Tunneltransistors ist die Schichtanordnung genau in der folgenden Reihenfolge vorgesehen:
Erstens die Emitter-Halbmetall-Magnetschicht, zweitens die Emitter-Basis-Tunnelbarriere, drittens die Halbleiterschicht ohne Spin-Anregungslücke, viertens die Basis-Kollektor-Tunnelbarriere, fünftens die Kollektor-Halbmetall-Magnetschicht. Ein besonders zuverlässiges Rekonfigurieren kann so ermöglicht werden.

Ein weiterer Aspekt der Erfindung betrifft ein Verfahren zum Konfigurieren und/oder Rekonfigurieren einer Stromdurchlassrichtung einer - insbesondere der erfindungsgemäßen - magnetischen Tunneldiode und/oder eines - insbesondere des erfindungsgemäßen - magnetischen Tunneltransistors, wobei zum Umkehren der Magnetisierungsrichtung des Halbleiters ohne Spin-Anregungslücke der Tunneldiode, des halbmetallischen Magneten der Tunneldiode und/oder der Halbleiterschicht ohne Spin-Anregungslücke des Tunneltransistors Strom mit einer Stromstärke größer als der Betriebsstromstärke angelegt oder ein externes Magnetfeld aktiviert wird.

Mit Stromdurchlassrichtung bei der Tunneldiode ist die Durchlassrichtung für Strom zwischen den zwei Anschlüssen gemeint, d.h. beispielsweise von einer unterer Elektrode zu einer oberen Elektrode oder umgekehrt.

Mit Stromdurchlassrichtung bei dem Tunneltransistor ist die die Durchlassrichtung für Strom zwischen einem Emitter und einem Kollektor gemeint, d.h. von der Emitter-Halbmetall-Magnetschicht zur Kollektor-Halbmetall-Magnetschicht oder umgekehrt.

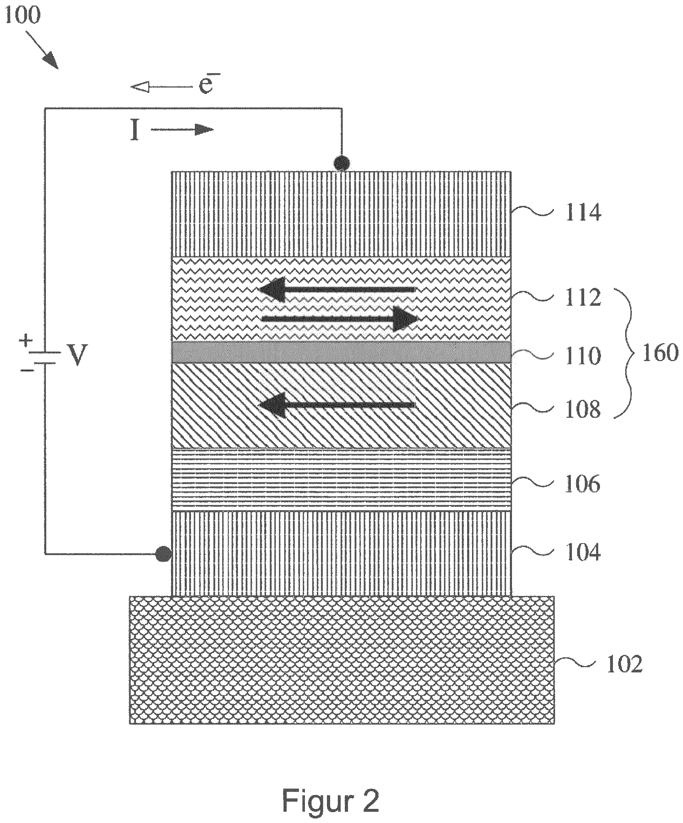

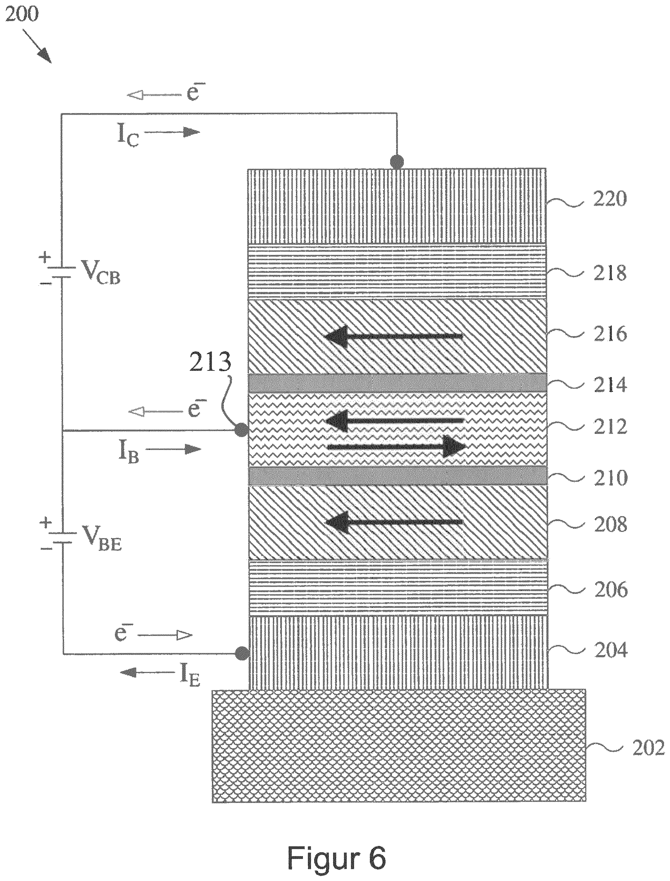

Bei der Tunneldiode ist der Strom (I, Fig. 2) zwischen den beiden Anschlüssen bzw. Elektroden gemeint. Bei dem Tunneltransistor ist der Strom der Stroms ($I_B$, Fig. 6) zwischen Emitter und Basis und/oder zwischen Kollektor und Basis ($I_E$ Fig. 6) gemeint, wobei die Erhöhung des Stroms insbesondere durch ein kurzzeitige Anheben der entsprechenden Spannung (V, $V_{CB}$ und/oder $V_{BE}$) über die Höhe der normalen Betriebsspannung - im Falle der Spannung $V_{BE}$ grundsätzlich im eingeschalteten Zustand - bewirkt werden kann.

Durch das strominduzierte oder mittels Magnetfeld bewirkten Umschaltens der Magnetisierungsrichtung kann ein besonders einfaches Rekonfigurieren ermöglicht werden.

Ein weiterer Aspekt der Erfindung betrifft die Verwendung eines Halbleiters ohne Spin-Anregungslücke in einer - insbesondere der erfindungsgemäßen - magnetischen Tunneldiode oder einer Halbleiterschicht ohne Spin-Anregungslücke in einem - insbesondere des erfindungsgemäßen - magnetischen Tunneltransistor zur Erzielung der Eigenschaften Nichtflüchtigkeit und/oder Rekonfigurierbarkeit einer Stromdurchlassrichtung.

Logik- und/oder Speicheroperationen oder die Kombination von Logik- und Speicheroperationen kann so ermöglicht werden.

Ein weiterer Aspekt der Erfindung betrifft die Verwendung eines Halbleiters ohne Spin-Anregungslücke in einer - insbesondere der erfindungsgemäßen - magnetischen Tunneldiode oder einer Halbleiterschicht ohne Spin-Anregungslücke in einem - insbesondere dem erfindungsgemäßen - magnetischen Tunneltransistor zur Erzielung eines inversen Tunnelmagnetowiderstand-Effekts.

Mit inversem TMR-Effekt ist gemeint, dass der TMR das Vorzeichen wechselt, wenn die Polarität der angelegten Vorspannung wechselt.

Logikbausteine können so besonders kompakt und mit besonders geringem Aufwand und Energieverbrauch bereitgestellt werden.

Insbesondere ist bei dieser Verwendung die Materialschicht aus dem halbmetallischen Magneten der magnetischen Tunneldiode, die Emitter-Halbmetall-Magnetschicht oder die Kollektor-Halbmetall-Magnetschicht des magnetischen Tunneltransistors aus einem ferromagnetischen oder ferrimagnetischen Material, wie z.B. Co oder Fe. Vorzugsweise kann ein solcher Tunnelkontakt den Aufbau SGS/MgO/Fe oder SGS/MgO/Co haben.

Eine besonders einfache Realisierung eines Logikbausteins kann so ermöglicht werden.

Nachfolgend werden Ausführungsbeispiele der Erfindung anhand von Figuren näher erläutert. Merkmale des Ausführungsbeispiels können einzeln oder in einer Mehrzahl mit dem beanspruchten Gegenstand kombiniert werden.

Ein weiterer Aspekt der Erfindung betrifft ein Verfahren, bei dem der erfindungsgemäße magnetische Tunneltransistor durch Anlegen einer Spannung zwischen Basis und Emitter ($V_{BE} > 0$) angeschaltet, d.h. ein Stromfluss durchgelassen wird, und durch Reduzieren der Spannung zwischen Basis und Emitter $V_{BE}$ auf Null ausgeschaltet werden kann, wobei die Spannung zwischen Basis und Kollektor $V_{CB}$ grundsätzlich größer als Null ist. Ein besonders einfaches an- und ausschalten kann so ermöglicht werden.

Es zeigen:

Figuren 1a und 1b: Schematische Darstellungen der Zustandsdichte (DOS) der Elektronen jeweils in einem halbmetallischen Magneten (HMM, Fig. 1a) und einem Halbleiter ohne Spin-Anregungslücke (SGS, Fig. 1b).

Figur 2: Schematische Querschnittsansicht der Schichten einer erfindungsgemäßen rekonfigurierbaren magnetischen Tunneldiode (RMTD) nebst elektrischen Anschlüssen.

Figuren 3a und 3b: Schematische Darstellungen der antiparallelen (Fig. 3a) und parallelen Orientierung (Fig. 3b) der Magnetisierungsrichtungen und der entsprechenden Strom-Spannungs-Eigenschaften bzw. I-V-Ausgangssignalfunktion der magnetischen Tunneldiode.

Figuren 4a bis 4f: Schematische Darstellungen der Zustandsdichte (DOS) der Elektronen in antiparalleler Konfiguration (4a bis 4c) der magnetischen Tunneldiode aus Fig. 3a bei verschiedenen Vorspannungen sowie bei paralleler Konfiguration (4d bis 4e) der magnetischen Tunneldiode aus Fig. 3b.

Figur 5: Schematische Darstellung der Abhängigkeit von der Vorspannung des Tunnelmagnetowiderstand-Effekts der in Fig. 2 gezeigten rekonfigurierbaren magnetischen Tunneldiode.

Figur 6: Schematische Querschnittsansicht eines erfindungsgemäßen rekonfigurierbaren magnetischen Tunneltransistors (RMTT) nebst elektrischen Anschlüssen.

Figuren 7a bis 7c: Schematisches Banddiagramm eines erfindungsgemäßen rekonfigurierbaren magnetischen Tunneltransistors in den Betriebsarten: Bandausrichtung (engl. band alignment) im Flachbandfall (Fig. 7a), im Sperrzustand (Fig. 7b) und im Durchlasszustand (Fig. 7c).

Figuren 8a bis 8c: Schematische Darstellung der Zustandsdichte (DOS) der Elektronen des rekonfigurierbaren magnetischen Tunneltransistors in den Betriebsarten: Bandausrichtung im Flachbandfall ohne externe Vorspannung (Fig. 8a), im Sperrzustand mit positiver Kollektor-Vorspannung (Fig. 8b) und im Durchlasszustand mit positiver Kollektor-Vorspannung und positiver Basis-Vorspannung.

Figuren 9a und 9b: Elektronen-Bandstruktur (Fig. 9a) und Zustandsdichten (Fig. 9b) des Halbleiters ohne Spin-Anregungslücke aus FeVZrSi gemäß einer erfindungsgemäßen magnetischen Tunneldiode oder eines erfindungsgemäßen magnetischen Tunneltransistors.

In einem magnetischen Material ist die Zustandsdichte (DOS) in ein Spin-up-Band - auch Majoritäts-Spin-Band genannt - und ein Spin-down-Band - auch Minoritäts-Spin-Band genannt - unterteilt.

In halbmetallischen Magneten (HMMs) zeigen die Majoritäts-Spin-Elektronen das Verhalten von Metall in einem endlichen Energieintervall um die Fermienergie $E_F$, während Minoritäts-Spin-Elektronen aufgrund der in Fig. 1a dargestellten Bandlücke $G_{CB}$ und $G_{VB}$ halbleitende Eigenschaften aufweisen, wobei $G_{VB}$ der Abstand zwischen Fermienergie und Valenzband ist und $G_{CB}$ der Abstand zwischen Fermienergie und Leitungsband (engl. conduction band). Dies führt zur 100 %igen Polarisierung der Leitungselektronen mit der Fermienergie $E_F$.

Wie in Fig. 1b gezeigt, haben die Halbleiter ohne Spin-Anregungslücke (SGS), die in Tunneldioden und Tunneltransistoren gemäß der vorliegenden Erfindung verwendet werden, eine besondere Bandstruktur, derart, dass eine Bandlücke der Majoritäts-Spin-Elektronen über der Fermienergie und eine Bandlücke der Minoritäts-Spin-Elektronen unterhalb der Fermienergie liegen - oder umgekehrt -, was zu einer 100 %igen Elektronen-Spin-Polarisierung des Valenzbandes und des Leitungsbandes in jeweils entgegengesetzter Richtung führt. Dieser spezielle Halbleiter ohne Spin-Anregungslücke wird auch als Halbleiter mit indirekter Bandlücke bezeichnet.

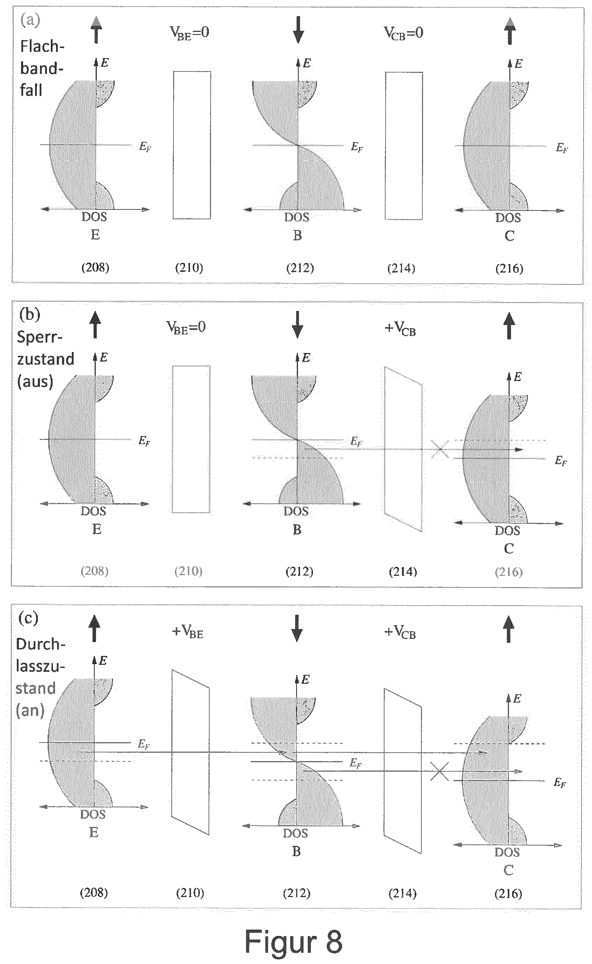

Die Figuren 1a und 1b sowie die Figuren 4, 8 und 9b können daher so gelesen werden, dass auf der linken Seite von der Vertikalachse die Majoritäts-Spin-Bänder und auf der rechten Seite die Minoritäts-Spin-Bänder dargestellt sind. Ferner sind unterhalb der horizontal eingezeichneten Fermienergie $E_F$ die Energiebänder bzw. Valenzbänder grundsätzlich besetzt, während die Energiebänder bzw. Leitungsbänder oberhalb der Fermienergie $E_F$ grundsätzlich unbesetzt sind und daher bei Anliegen einer Spannung lediglich als Durchgangsstation dienen können. So kann z.B. wie in Fig. 8c dargestellt ein Elektron des unterhalb der Fermieenergie-Horizontalen angeordneten und somit besetzten Majoritäts-Spin-Bandes des Emitters E temporär zum unbesetzten Majoritäts-Spin-Bandes der Basis oberhalb der Fermieenergie-Horizontalen wandern, um von dort gleich zum ebenfalls unbesetzten Majoritäts-Spin-Bandes des Kollektors zu gelangen und von dort über die obere Elektrode 220 abzufließen.

Spin-aufgelöste Photoelektronenspektroskopie (PES), auch als Photoemissionsspektroskopie bezeichnet, ist eine sehr leistungsfähige Methode zur Verifikation eines halbmetallischen Magnets, eines Halbleiters ohne Spin-Anregungslücke oder eines anderen Magnetmaterials. PES stellt nämlich einen direkten Weg zur Identifizierung der elektronischen Struktur von Materialien bereit und funktioniert daher grundsätzlich zuverlässiger und ermöglicht eine umfassenderer Information über die elektronische Struktur magnetischer Materialien verglichen mit indirekten Verfahren wie z.B. die spin-polarisierte Rastertunnelmikroskopie oder die spin-polarisierte Positronen-Annihilations-Spektroskopie. Eine Diode ist grundsätzlich ein elektronisches Bauteil mit zwei Anschlüssen zum Durchlassen eines elektrischen Stromflusses nur in eine Richtung und zum Blockieren eines Stromflusses in die entgegengesetzte Richtung.

Die Figur 2 zeigt exemplarisch eine erfindungsgemäße rekonfigurierbare magnetische Tunneldiode 100 vorzugsweise mit einem Aufbau in Form eines Materialschichtstapels (engl. Stacks) mit übereinander angeordneter und/oder fest miteinander verbundener Schichten. Die Tunneldiode 100 umfasst eine elektrisch isolierende Trägerschicht 102, eine darauf angeordnete untere Elektrode 104 zum elektrischen Anschließen des halbmetallischen Magneten 108 insbesondere an einen externen Stromkreis mit der Spannung V, eine darauf angeordnete Feststellschicht 106 zum Fixieren einer Magnetisierungsrichtung einer an die Feststellschicht 106 angrenzenden Schicht, ein Tunnelkontakt 160 umfassend oder bestehend aus drei Schichten und/oder eine auf dem Tunnelkontakt 160 angeordneten oberen Elektrode 114 zum elektrischen Anschließen eines magnetischen Halbleiters ohne Spin-Anregungslücke 112 an den externen Stromkreis. Der externe Stromkreis kann eine Spannung zwischen der unteren Elektrode 104 und der oberen Elektrode 114 und/oder zwischen dem halbmetallischen Magneten 108 anlegen.

Der Tunnelkontakt 160 umfasst oder besteht aus einem halbmetallischen Magneten 108 grundsätzlich mit Spin-Anregungslücke, der vorzugsweise durch die Feststellschicht 106 eine fixierte Magnetisierungsrichtung aufweist, einer auf dem halbmetallischen Magneten 108 angeordneten Tunnelbarriere 110 als Isolator zwischen den zwei an die Tunnelbarriere 110 angrenzenden Schichten, und einem auf der Tunnelbarriere 110 angeordneten Halbleiter ohne Spin-Anregungslücke 112, dessen Magnetisierungsrichtung rekonfigurierbar, also umschaltbar oder umkehrbar, ist.

In einer Ausführungsform der magnetischen Tunneldiode sind die Schichten halbmetallischen Magneten 108 und Halbleiter ohne Spin-Anregungslücke 112 vertauscht, wodurch dann die Magnetisierungsrichtung des Halbleiters ohne Spin-Anregungslücke 112 fixiert und die Magnetisierungsrichtung des halbmetallischen Magneten rekonfigurierbar ist.

In einer Ausführungsform umfasst oder besteht der Träger 102 aus MgO oder $SiO_2$. Eine zuverlässige Funktion der Diode kann so sichergestellt werden.

In einer Ausführungsform umfasst oder besteht die untere Elektrode 104 und/oder die obere Elektrode 114 aus Ti, Ru, Rh, Cu, N, Al, Ta, CuN oder einer Kombination mindestens zwei dieser Materialien insbesondere in Form eines Multischichtsystems. Eine zuverlässige Funktion der unteren und oberen Elektrode kann so sichergestellt werden.

Insbesondere weisen die obere Elektrode 104 und/oder untere Elektrode 114 eine flächig ausgedehnte Form mit einer Dicke von mindestens 10 nm und/oder höchstens 100 nm, vorzugsweise höchstens 50 nm, besonders bevorzugt höchstens 30 nm auf. Eine kompakte Bauweise und dennoch zuverlässige Funktion kann erzielt werden.

In einer Ausführungsform umfasst oder besteht die Feststellschicht 106 aus einem anti-ferromagnetischen Material und/oder einem halbmetallischen Magneten, vorzugsweise FeMn, NiMn, PtMn, IrMn, PdMn, PtPdMn oder RhMn. Grundsätzlich kann die Feststellschicht 106 eine Magnetisierungsrichtung in Schichtebene oder unter einem Winkel zur Schichtebene, vorzugsweise 90°, aufweisen. Ein zuverlässiges Feststellen oder Fixieren des Spins, also der Magnetisierungsrichtung, in einer angrenzenden magnetischen Schicht, beispielsweise des halbmetallischen Magneten 108, kann so ermöglicht werden.

Insbesondere weisen die Feststellschicht eine flächig ausgedehnte Form mit einer Dicke von mindestens 10 nm und/oder höchstens 100 nm, vorzugsweise höchstens 50 nm, besonders bevorzugt höchstens 30 nm auf. Eine kompakte Bauweise und dennoch zuverlässige Funktion kann erzielt werden.

In einer Ausführungsform ist der halbmetallische Magnet 108 und/oder der Halbleiter ohne Spin-Anregungslücke 112 so beschaffen, dass die Magnetisierungsrichtung oder das magnetische Moment in Anwesenheit eines Magnetfeldes festgestellt oder fixiert werden kann, d.h. eine Umkehr der Magnetisierungsrichtung oder des magnetischen Moments kann durch die Anwesenheit des Magnetfelds verhindert werden. Insbesondere ist der halbmetallische Magnet 108 und/oder der Halbleiter ohne Spin-Anregungslücke 112 dazu ferromagnetisch oder ferrimagnetisch.

In einer Ausführungsform umfasst oder besteht der halbmetallische Magnet 108 aus einem Material mit einer Curie-Temperatur oberhalb der Raumtemperatur und/oder mit einer großen halbmetallischen Bandlücke wie z.B. halbmetallische vollständige Heusler'sche Legierungen wie $Co_2YZ$, wobei Y=Ti, V, Cr, Mn, Fe, und Z= Al, Ga, In, Si, Ge, Sn, As, Sb und umgekehrte Heusler'sche Legierungen mit der chemischen Formel $X_2YZ$, wobei X=Sc, Ti, V, Cr, Mn und Z=Al, Si, As und Y = Ti bis Zn, sowie halbe Heusler'sche Legierungen XYSb, wobei X= Fe, Co, Ni und Y=Mn.

Insbesondere weist der halbmetallische Magnet 108 eine flächig ausgedehnte Form mit einer Dicke von mindestens 1 nm, bevorzugt 5 nm, besonders bevorzugt 10 nm, und/oder höchstens 50 nm, vorzugsweise höchstens 40 nm, besonders bevorzugt höchstens 30 nm auf. Eine kompakte Bauweise und dennoch zuverlässige Funktion kann erzielt werden.

In einer Ausführungsform umfasst oder besteht die Tunnelbarriere 110 aus einem Isolatorwerkstoff, der insbesondere eine Bandlücke von mindestens 0,4 eV aufweist, vorzugsweise MgO oder $AlO_x$, grundsätzlich aber auch $AlO_x$, MgAlO, $TaO_x$, $SiO_2$, $HfO_2$, intrinsische Halbleiter wie z.B. Si, GaAs, und zweidimensionale Systeme wie z.B. hexagonales BN. Eine zuverlässige Barrierefunktion kann so sichergestellt werden.

Insbesondere weist die Tunnelbarriere 110 eine flächig ausgedehnte Form mit einer Dicke von mindestens 0,5 nm, bevorzugt 1 nm, und/oder höchstens 5 nm, vorzugsweise höchstens 4 nm, besonders bevorzugt höchstens 2 nm auf. Eine zuverlässige Barrierefunktion der Tunnelbarriere 110 kann so ermöglicht werden, während zu dicke Schichtstärken zu stark den Tunneleffekt hindern und noch dünnere Schichtstärken im Elektrischen Feld zusammenbrechen können.

In einer Ausführungsform umfasst oder besteht der Halbleiter ohne Spin-Anregungslücke 112 aus einem magnetischen Werkstoff, der insbesondere eine Magnetisierungsrichtung in Schichtebene oder unter einem Winkel zur Schichtebene aufweist. Grundsätzlich ist der Halbleiter ohne Spin-Anregungslücke 112 so beschaffen, dass die Magnetisierungsrichtung des Halbleiters ohne Spin-Anregungslücke 112 in Anwesenheit eines Magnetfeldes konfiguriert und auch im Betrieb der Tunneldiode rekonfiguriert, also umgekehrt, werden kann. Eine Umstellung der Stromleitrichtung der Tunneldiode im Betrieb kann so ermöglicht werden.

Vorzugsweise umfasst oder besteht der Halbleiter ohne Spin-Anregungslücke 112 aus einer quartären Heusler'schen Legierungen (engl. quaternary Heusler compounds) wie z.B. FeCrXZ, FeVXZ', and MnVXZ" Verbindungen, wobei X= Ti, Zr, Hf, Z=Al, Ga, In, Z'=Si, Ge, Sn, und Z"=P, As, Sb ist. Grundsätzlich kommt für den Halbleiter ohne Spin-Anregungslücke 112 jedes Material mit Halbleitereigenschaft ohne Spin-Anregungslücke vorzugsweise mit einer Curie-Temperatur oberhalb der Raumtemperatur in Betracht.

Insbesondere weist der Halbleiter ohne Spin-Anregungslücke 112 eine flächig ausgedehnte Form mit einer Dicke von mindestens 1 nm, bevorzugt 2 nm, und/oder höchstens 40 nm, vorzugsweise höchstens 20 nm, besonders bevorzugt höchstens 8 nm auf. Ein zuverlässiges Rekonfigurieren kann so ermöglicht werden, wo hingegen bei dickeren Schichten zumindest ein strominduziertes Spin-Transfer-Drehmoment-Rekonfigurieren ggf. nicht mehr erzielt werden kann. Eine optimale Schichtdicke für den Halbleiter ohne Spin-Anregungslücke 112 beträgt regelmäßig genau oder ungefähr 3 nm. Eine Herstellbarkeit der Halbleiterschicht ohne Spin-Anregungslücke 112 mit reproduzierbaren Eigenschaften und eine zuverlässige Funktion der Tunneldiode kann so ermöglicht werden.

In einem ersten exemplarischen Ausführungsbeispiel umfasst eine erfindungsgemäße magnetische Tunneldiode 100, die in Figur 2 schematisch dargestellt ist, einen Träger 102 aus MgO, eine unteren Elektrode 104 aus Ta mit 20 nm Schichtdicke, eine Feststellschicht 106 aus IrMn mit 10 nm Schichtdicke, einen halbmetallischen Magneten 108 aus $Co_2MnSi$ mit 20 nm Schichtdicke, eine Tunnelbarriere 110 aus MgO mit 1 nm Schichtdicke, einen Halbmetall ohne Spin-Anregungslücke 112 aus FeVTiSi mit 2 nm Schichtdicke und/oder eine obere Elektrode 114 aus Ta mit 20 nm Schichtdicke. Die so aufgebaute magnetische Tunneldiode 100 zeigte die Funktionen Nichtflüchtigkeit und Rekonfigurierbarkeit der Durchlassrichtung sowie den inversen TMR-Effekt.

Ein Rekonfigurieren durch strominduziertes Umschalten der Magnetisierungsrichtung der Halbmetallschicht ohne Spin-Anregungslücke 212 aus FeVTiSi kann durch Anlegen eines Stroms (I, Fig. 2) größer als dem Betriebsstrom in Höhe einer kritischen Stromdichte $I_{cr}$ von ungefähr $10^7$ $A/cm^2$ bewirkt werden.

In einem zweiten exemplarischen Ausführungsbeispiel umfasst eine erfindungsgemäße magnetische Tunneldiode 100, die in Figur 2 unter Vertauschen der Schichten 108 und 112 schematisch dargestellt ist, einen Träger 102 aus MgO, darauf eine unteren Elektrode 104 aus Ta mit 20 nm Schichtdicke, darauf eine Feststellschicht 106 aus IrMn mit 10 nm Schichtdicke, darauf einen Halbmetall ohne Spin-Anregungslücke aus FeVZrSi mit 8 nm Schichtdicke, darauf eine Tunnelbarriere 110 aus MgO mit 3 nm Schichtdicke, darauf einen halbmetallischen Magneten aus $Co_2FeAl$ mit 30 nm Schichtdicke und/oder darauf eine obere Elektrode 114 aus Ta mit 20 nm Schichtdicke. Die so aufgebaute magnetische Tunneldiode 100 zeigte ebenfalls die Funktionen Nichtflüchtigkeit und Rekonfigurierbarkeit der Durchlassrichtung sowie den inversen TMR-Effekt.

In einem dritten exemplarischen Ausführungsbeispiel umfasst eine erfindungsgemäße magnetische Tunneldiode 100, die in Figur 2 schematisch dargestellt ist, einen Träger 102 aus MgO, eine unteren Elektrode 104 aus Ta mit 20 nm Schichtdicke, eine Feststellschicht 106 aus IrMn mit 10 nm Schichtdicke, einen halbmetallischen Magneten 108 aus $Co_2FeAl_{0,5}Si_{0,5}$ mit 10 nm Schichtdicke, eine Tunnelbarriere 110 aus MgO mit 1 nm Schichtdicke, einen Halbmetall ohne Spin-Anregungslücke 112 aus FeVZrGe mit 2 nm Schichtdicke und/oder eine obere Elektrode 114 aus Ta mit 20 nm Schichtdicke. Die so aufgebaute magnetische Tunneldiode 100 zeigte ebenfalls die Funktionen Nichtflüchtigkeit und Rekonfigurierbarkeit der Durchlassrichtung sowie den inversen TMR-Effekt.

Eine oder sämtliche Schichten der magnetischen Tunneldiode 100 der Fig. 2 kann durch Abscheidungsverfahren oder Beschichtungstechniken wie z.B. Magnetron-Sputtern, Radiofrequenz-Sputtern und/oder Elektronenstrahlverdampfung hergestellt werden.

Insbesondere werden mindestens zwei oder sämtliche Schichten der magnetischen Tunneldiode 100 der Fig. 2 durch sukzessives Abscheiden in einer Ultrahochvakuumkammer mittels Anwendung von Magnetron-Sputtern und Elektronenstrahlverdampfung hergestellt.

So wurde in dem ersten exemplarischen Ausführungsbeispiel die Ta-Schicht als spätere Elektrode bei Raumtemperatur auf ein MgO-Trägersubstrat durch Magnetron-Sputtern aufgetragen und darauf die IrMn-Schicht als Feststellschicht ebenfalls bei Raumtemperatur mit Magnetron-Sputtern erzeugt. Auf die Feststellschicht wurde zunächst durch Magnetron-Sputtern bei Raumtemperatur $Co_2MnSi$ abgeschieden und anschließend getempert bei ungefähr 500°C, um ein epitaxiales Wachstum der $Co_2MnSi$-Schicht zu bewirken. Idealerweise kristallisiert dabei die Co2MnSi-Schicht in der kubischen $L2_1$Typ-Struktur und die Zelleinheiten umfassen dann vier interpenetrierende fcc Untergitter mit den Positionen (0, 0, 0) und (0,5 0,5 0,5) für Co-Atome, (0,25, 0,25, 0,25) für das Mn-Atom und (0,75, 0,75, 0,75) für das Si-Atom.

Die MgO-Tunnelbarriere kann dann durch Abscheiden auf die $Co_2MnSi$-Schicht vorzugsweise mittels Elektronenstrahlverdampfung bei Raumtemperatur erzeugt werden. Die FeVTiSi-Schicht kann ebenfalls bei Raumtemperatur vorteilhaft durch Magnetron-Sputtern mit anschließendem Tempern insbesondere bei ungefähr 500°C zur Erzielung eines epitaxialen Wachstum der FeVTiSi-Schicht auf die darunter liegende MgO-Tunnelbarriere aufgetragen werden. Ähnlich wie bei der $Co_2MnSi$-Schicht kann dadurch die FeVTiSi-Schicht idealerweise in kubisch quartäre Heusler-Typ-Struktur mit den Positionen (0, 0, 0) für das Fe-Atom, (0.25, 0.25, 0.25) für das Ti-Atom, (0.5, 0.5, 0.5) für das V-Atom und (0.75, 0.75, 0.75) für das Si-Atom kristallisieren.

Die Ta-Schicht kann als spätere Elektrode vorzugsweise ebenfalls mit Magnetron-Sputtern aufgetragen werden.

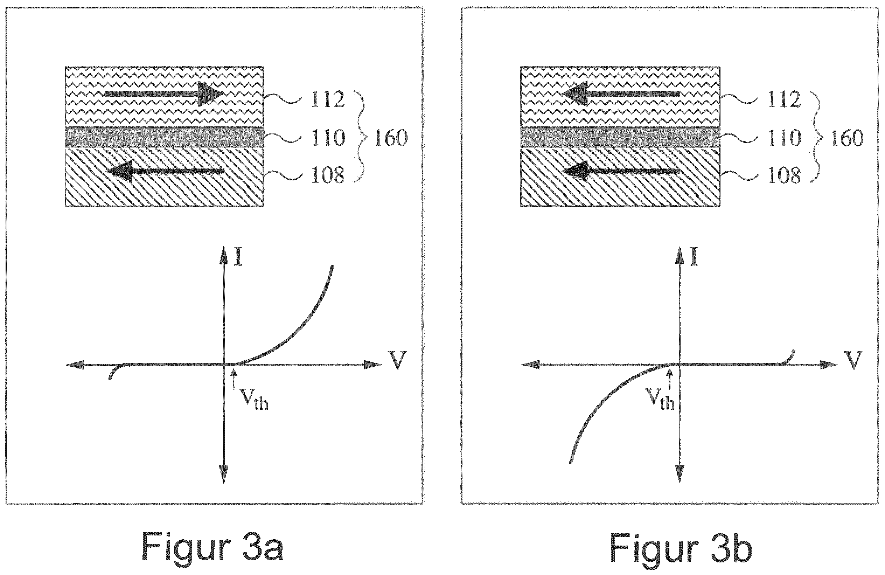

Die oben beschriebenen Rektifizierungseigenschaften der Tunneldiode sind abhängig von der relativen Orientierung der Magnetisierung der magnetischen Schichten 108 und 112. Wenn die Magnetisierung des halbmetallischen Magneten 108 und des Halbleiters ohne Spin-Anregungslücke 112 wie in Fig. 3a antiparallel ist, dann ist der Tunnelstrom nur in einer Richtung möglich, während er in der anderen Richtung blockiert ist; der Tunnelkontakt 160 weist also Diodenverhalten auf. Wird die Magnetisierung des Halbleiters ohne Spin-Anregungslücke umgekehrt, verläuft sie also parallel zum halbmetallischen Magneten 108, dann sind die Rektifizierungseigenschaften der Tunneldiode ebenso umgekehrt, wie Fig. 3b zeigt.

Wenn wie in Fig. 3a gezeigt eine positive Spannung V oder ein positives Spannungssignal zwischen den Anschlüssen der Diode anliegt, beginnt die Diode erst ab einer kritischen Spannung oder Schwellenspannung $V_{th}$ Strom zu leiten. Nach der Schwellspannung ist ein exponentieller Anstieg des Stroms I über der Spannung V zu verzeichnen. Wenn der Strom zu hoch wird, besteht jedoch grundsätzlich die Gefahr von Rissen in der Diode und Melzen der Diode. Bei negativen Spannungen wird kein oder nahezu kein Strom I in die entgegengesetzte Richtung geleitet. Der Vollständigkeit sei angemerkt, dass grundsätzlich durch sehr hohe negative Spannungen insbesondere jenseits eines üblichen Betriebsbereiches der Diode dennoch ein Stromfluss bewirkt werden kann.

In einem Ausführungsbeispiel ist die Tunneldiode so beschaffen, dass bei Umkehr der Magnetisierungsrichtung der Halbleiterschicht ohne Spin-Anregungslücke 112 auch die Strom-Spannungskurve (I-V) umgekehrt, d.h. um die Spannungs- und Stromachse gespiegelt, werden kann (vgl. Fig. 3a, 3b). Die Diode kann so konfiguriert werden.

Das bedeutet, dass die Tunneldiode durch ein externes Magnetfeld oder einen strominduzierten Spin-Transfer-Drehmoment-Mechanismus dynamisch konfiguriert werden kann.

In der Tunneldiode nach Figur 2 ist die Magnetisierungsrichtung des halbmetallischen Magneten 108 fixiert und die Magnetisierungsrichtung des Halbleiters ohne Spin-Anregungslücke 112 ist frei drehbar.

Ein vorteilhafter Effekt der erfindungsgemäßen Tunneldiode ist, dass die Schwellenspannung $V_{th}$, bei der die Diode den Strom passieren lässt, von der Dicke und der Potenzialhöhe der isolierenden Barriere abhängig ist und somit $V_{th}$ mit der korrekten Auswahl dieser beiden Parameter angepasst werden kann.

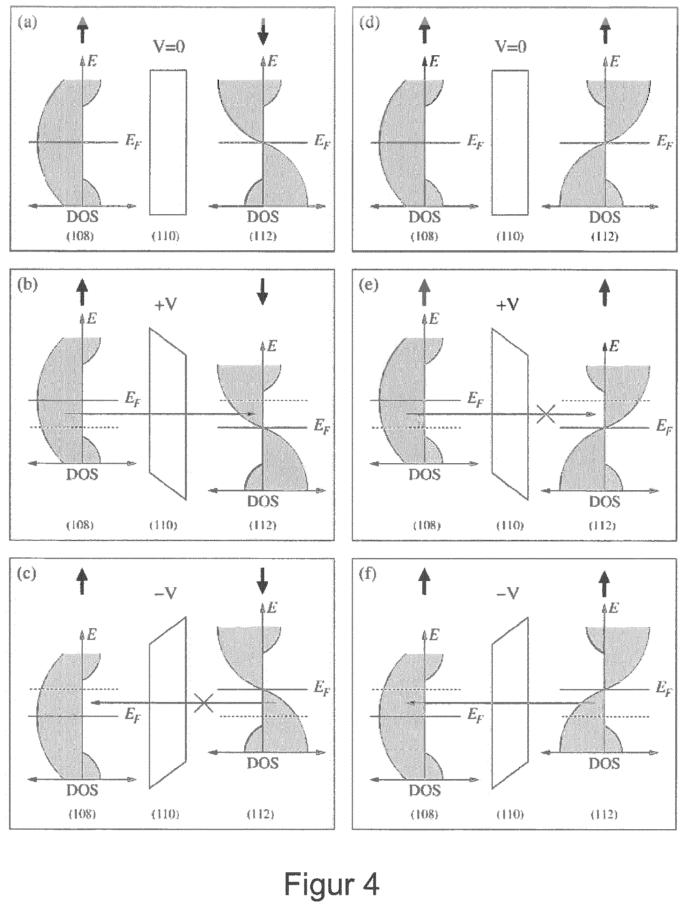

In halbleiterbasierten Dioden ist die Schwellenspannung $V_{th}$ normalerweise feststehend kann nicht geändert werden. Beispielsweise liegt die Schwellenspannung $V_{th}$ bei Dioden aus oder mit Germanium ungefähr bei 0,3 V und bei Dioden aus oder mit Silizium bei ungefähr 0,7 V. Wie in Fig. 4 gezeigt, kann das bidirektionale Verhalten der Tunneldiode mit der Zustandsdichte der magnetischen Schichten 108 und 112, also des halbmetallischen Magneten 108 und des Halbleiters ohne Spin-Anregungslücke 112, unter positiver und negativer Vorspannung erklärt werden.

Das Energiebanddiagramm der isolierenden Tunnelbarriere ist in Figur 4 rechteckig dargestellt, wenn keine Vorspannung an den Elektroden anliegt, und trapezförmig, wenn eine endliche Vorspannung an einer der Elektroden anliegt.

Im Simmons-Modell wird der Tunnel-Strom $I(V)$ für die Vorspannung $V$ gegeben durch den Ausdruck

$$I(V) \sim \sum_{\sigma} \int_{-\infty}^{\infty} \rho_{HMM}^{\sigma}\left(E\right)\rho_{SGS}^{\sigma}\left(E+eV\right)\left|T\left(V\right)\right|^2 f\left(E\right)\left[1-f\left(E+eV\right)\right]dE,$$

wobei $\rho_{HMM}^{\sigma}\left(E\right)$ und $\rho_{SGS}^{\sigma}\left(E+eV\right)$ die Zustandsdichten der beiden magnetischen Schichten 108 und 112 mit Spin $\sigma$ angeben und $f(E)$ die Fermi-Verteilungsfunktion ist. $T(V)$ ist die Transmissionswahrscheinlichkeit und proportional zu $e^{-d\sqrt{\phi-V}}$, wobei $d$ die Dicke der Tunnelbarriere 110 und $\phi$ deren Höhe ist.

Wie in Fig. 4b dargestellt, tunneln Elektronen vom besetzten Majoritäts-Spin-Valenzband des halbmetallischen Magneten 108 durch die isolierende Tunnelbarriere 110 hindurch in das nicht besetzte Minoritäts-Spin-Leitungsband des Halbleiters ohne Spin-Anregungslücke 112, wenn eine positive Vorspannung an der unteren Elektrode 104 und damit dem Halbleiters ohne Spin-Anregungslücke 112 angelegt wird. Für den anderen Spinkanal ist Elektronentunneln nicht möglich, da keine Zustände vorhanden sind, die beim halbmetallischen Magneten 108 unter der Fermienergie und beim Halbleiters ohne Spin-Anregungslücke 112 über der Fermienergie liegen, es sei denn die angelegte Vorspannung ist zu hoch.

Die gestrichelten Linien in Figur 4 zeigen den Energiebereich derjenigen Elektronen, denen es gelingt, durch die Barriere zu tunneln. Wenn an den Halbleiter ohne Spin-Anregungslücke 112 eine negative Spannung angelegt wird, verhindert dies aufgrund der besonderen Bandstruktur des HMM-I-SGS-Tunnelkontakts 160 das Tunneln der Elektronen zum halbmetallischen Magneten 108 und damit zur oberen Elektrode 114. Wenn die Elektroden parallel magnetisiert sind, wie in Fig. 4a bis 4c, fließt in die entgegengesetzte Richtung ein Elektronenstrom, d. h. von der unteren Elektrode 104 zur oberen Elektrode 114. So kann eine HMM-I-SGS-Tunneldiode dynamisch konfiguriert werden, also eine magnetische Tunneldiode mit einer Schicht halbmetallischen Magneten 108, darüber der Tunnelbarriere 110 und darüber eine Schicht Halbleiters ohne Spin-Anregungslücke 112.

Insbesondere weist die vorliegende Tunneldiode die Eigenschaft eines inversen Tunnelmagnetowiderstands-Effekts (TMR) auf bzw. ist so beschaffen, dass sie diesen ermöglichen kann. Der TMR-Effekt tritt grundsätzlich in einem Tunnelkontakt auf, der z.B. zwei Ferromagneten getrennt durch einen dünnen Isolator umfasst. Wenn die Isolatorschicht dünn genug, also z.B. im einstelligen Nanometerbereich, können Elektronen von dem einen Ferromagneten zum anderen durch die Isolatorschicht tunneln. Der TMR-Effekt ist ein quantenmechanisches Phänomen, dass nicht durch die klassische Physik beschrieben werden kann. In einem Tunnelkontakt kann die Magnetisierungsrichtung eines der Ferromagneten durch eine externes Magnetfeld oder durch induzierten Strom umgeschaltet bzw. umgekehrt werden. Wenn die Magnetisierungsrichtungen parallel orientiert sind, ist es eher wahrscheinlich, dass Elektronen durch die Isolatorschicht tunneln als bei anti-parallelen bzw. entgegengesetzten Magnetisierungsrichtungen der beiden Ferromagneten. Daraus folgt, dass ein solcher Tunnelkontakt grundsätzlich zwischen zwei elektrischen Widerstandszuständen geschaltet werden kann: einer mit niedrigem und einer mit hohem Widerstand.

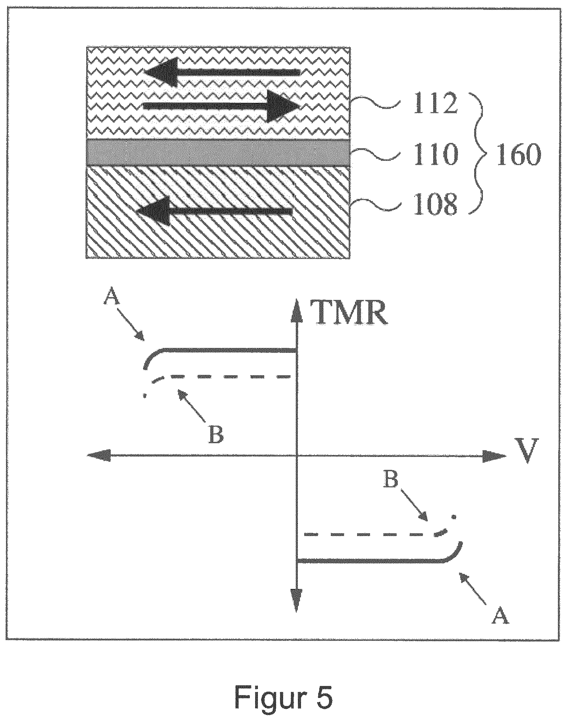

Die Figur 5 stellt die Abhängigkeit des TMR-Effekts für zwei Fälle dar: Mit "A" gekennzeichnet ist die Spannungsabhängigkeit des TMR-Wertes bei einer Tunneldiode 100 mit einem Tunnelkontakt 160 umfassend ein halbmetallischen Magneten 108 mit fixierter Magnetisierungsrichtung und dem Halbleiter ohne Spin-Anregungslücke 112 mit freier Magnetisierungsrichtung. Mit "B" gekennzeichnet ist die Spannungsabhängigkeit des TMR-Wertes bei einer Tunneldiode 100 mit einem Tunnelkontakt 160 umfassend einen normal ferromagnetischen oder ferrimagnetischen Werkstoff als Magnetschicht 108 mit fester Magnetisierungsrichtung und dem Halbleiter ohne Spin-Anregungslücke 112 mit freier Magnetisierungsrichtung. TMR ist definiert durch die Formel

$$TMR = \frac{R^{AP} - R^{P}}{R^{AP} + R^{P}} \times 100\,,$$

wobei $R^{AP}$ und $R^{P}$ die Widerstände des Tunnelkontakts bei antiparalleler und paralleler Orientierung der Magnetisierung der magnetischen Schichten 108 und 112 sind. Aufgrund der oben beschriebenen besonderen Energieband-Struktur des HMM-I-SGS-Tunnelkontakts 160 mit und ohne Anregungslücke (Fig. 1a und 1b) weist die rekonfigurierbare magnetische Tunneldiode den inversen TMR-Effekt auf, d.h. der TMR wechselt das Vorzeichen, wenn die Polarität der angelegten Vorspannung wechselt. Wie bereits erwähnt ist dies eine sehr wichtige Eigenschaft, die es ermöglicht, die rekonfigurierbare magnetische Tunneldiode zur Herstellung magnetischer Logikgatter für z.B. Computerprozessoren zu verwenden.

Dadurch, dass der HMM-I-SGS-Tunnelkontakt 160 grundsätzlich auch in dem magnetischen Tunneltransistor 200 der Figur 6 vorhanden ist, weist auch der magnetische Tunneltransistor 200 den inversen TMR-Effekt auf.

Wenn ein normaler Ferromagnet wie Fe, Co, CoFe, oder CoFeB im Tunnelkontakt 160 als magnetische Schicht 108 mit fixierter Magnetisierungsrichtung anstelle eines halbmetallischen Magneten eingesetzt wird, verliert die rekonfigurierbare magnetische Tunneldiode aus Fig. 2 die oben beschriebene Rektifizierungseigenschaft und der inverse TMR-Effekt würde zumindest mit reduzierten Werten bestehen bleiben. Der Halbleiter ohne Spin-Anregungslücke 112 spielt durch die oben beschriebene besondere Bandstruktur für dem Tunnelkontakt 160 eine wichtige Rolle für den inversen TMR-Effekt.

Ein Transistor ist grundsätzlich ein elektronisches Bauteil mit drei Anschlüssen, das verwendet wird, um elektrische Energie, vorzugsweise elektronische Signale, zu verstärken und/oder zu schalten. Eine Spannung oder ein Strom, der an einem Anschlusspaar des Transistors angelegt wird, kann den Stromfluss durch ein weiteres Anschlusspaar - wobei einer der Anschlüsse von beiden Paaren umfasst sein kann - ändern, also z.B. verstärken. Ein Transistor ist daher ein Grundbaustein einer integrierten Schaltung oder eines elektrischen Bauteils.

Ein Anschluss ist in der Regel eine Elektrode.

Figur 6 zeigt einen Querschnitt durch die Materialschichten eines rekonfigurierbaren magnetischen Tunneltransistor 200 nebst angeschlossener externer elektrischer Schaltkreise zum Anlegen einer Spannung $V_{CB}$ zwischen einer Kollektorelektrode 220 und einer Basiselektrode 213 sowie einer Spannung $V_{BE}$ zwischen der Basiselektrode 213 und der Emitterelektrode 204.

Der rekonfigurierbaren magnetischen Tunneltransistor 200 umfasst oder besteht aus einer isolierenden Trägerschicht 202, einer Emitterelektrode 204, einer insbesondere anti-ferromagnetischen Emitter-Feststellschicht 206, einer Emitter-Halbmetall-Magnetschicht 208, einer Emitter-Basis-Tunnelbarriere 210, einer Halbleiterschicht ohne Spin-Anregungslücke 212, einer Basis-Kollektor-Tunnelbarriere 214, einer Kollektor-Halbmetall-Magnetschicht 216, einer Kollektor-Feststellschicht 218 und/oder einer Kollektorelektrode 220. Die Basiselektrode 213 ist mit der Halbleiterschicht ohne Spin-Anregungslücke 212 elektrisch leitend verbunden.

Insbesondere ist bei dem rekonfigurierbaren erfindungsgemäßen magnetischen Tunneltransistor 200 anders als bei der rekonfigurierbaren magnetischen Tunneldiode 100 ein Vertauschen der Halbleiterschicht ohne Spin-Anregungslücke 212 mit der Emitter-Halbmetall-Magnetschicht 208 und/oder Kollektor-Halbmetall-Magnetschicht 216 nicht möglich.

Grundsätzlich weist der rekonfigurierbaren erfindungsgemäßen magnetischen Tunneltransistor 200 daher die Halbleiterschicht ohne Spin-Anregungslücke 212 genau und/oder unmittelbar zwischen der Emitter-Basis-Tunnelbarriere 210 und der Basis-Kollektor-Tunnelbarriere 214 auf.

Insbesondere umfasst oder besteht die Trägerschicht 202 aus MgO oder $SiO_2$. Die Emitterelektrode 204 und/oder die Kollektorelektrode 220 umfassen oder bestehen aus Ti, Ru, Rh, Cu, N, Al, Ta, CuN oder einer Kombination mindestens zwei dieser Materialien insbesondere in Form eines Multischichtsystems. Eine zuverlässige Funktion der Elektroden kann so sichergestellt werden.

Insbesondere weisen die Emitterelektrode 204 und/oder die Kollektorelektrode 220 eine Schichtdicke von mindestens 10 nm und/oder höchstens 100 nm, vorzugsweise höchstens 50 nm, besonders bevorzugt höchstens 30 nm auf. Eine kompakte Bauweise und dennoch zuverlässige Funktion kann erzielt werden.

In einer Ausführungsform umfassen oder bestehen die Emitter-Feststellschicht 206 und/oder Kollektor-Feststellschicht 218 aus einem anti-ferromagnetischen Material und/oder einem halbmetallischen Magneten, vorzugsweise FeMn, NiMn, PtMn, IrMn, PdMn, PtPdMn oder RhMn. Grundsätzlich können die Emitter-Feststellschicht 206 und/oder Kollektor-Feststellschicht 218 eine Magnetisierungsrichtung in Schichtebene oder unter einem Winkel zur Schichtebene, vorzugsweise 90°, aufweisen. Ein zuverlässiges Feststellen oder Fixieren der Magnetisierungsrichtung der jeweils angrenzenden Emitter- bzw. Kollektor-Halbmetall-Magnetschicht 208, 216 kann so ermöglicht werden.

Insbesondere weisen die Emitter-Feststellschicht 206 und/oder Kollektor-Feststellschicht 218 Schichtdicken von mindestens 10 nm und/oder höchstens 100 nm, vorzugsweise höchstens 50 nm, besonders bevorzugt höchstens 30 nm auf. Eine kompakte Bauweise und dennoch zuverlässige Funktion kann erzielt werden.

In einer Ausführungsform sind nur die Emitter-Halbmetall-Magnetschicht 208 und/oder Kollektor-Halbmetall-Magnetschicht 216 so beschaffen, dass die Magnetisierungsrichtung in Anwesenheit eines Magnetfeldes festgestellt oder fixiert werden kann, insbesondere durch die Emitter-Feststellschicht 206 bzw. die Kollektor-Feststellschicht 218. Vorzugsweise sind die Emitter-Halbmetall-Magnetschicht 208 und/oder Kollektor-Halbmetall-Magnetschicht 216 ferromagnetisch oder ferrimagnetisch und/oder umfassen oder bestehen aus einem Material mit einer Curie-Temperatur oberhalb der Raumtemperatur und/oder mit einer großen halbmetallischen Bandlücke wie z.B. halbmetallische vollständige Heusler'sche Legierungen wie $Co_2YZ$, wobei Y=Ti, V, Cr, Mn, Fe, und Z= Al, Ga, In, Si, Ge, Sn, As, Sb und umgekehrte Heusler'sche Legierungen mit der chemischen Formel $X_2YZ$, wobei X=Sc, Ti, V, Cr, Mn und Z=Al, Si, As und Y = Ti bis Zn, sowie halbe Heusler'sche Legierungen XYSb, wobei X= Fe, Co, Ni und Y=Mn.

Insbesondere weisen die Emitter-Halbmetall-Magnetschicht 208 und/oder Kollektor-Halbmetall-Magnetschicht 216 Schichtdicken von mindestens 1 nm, bevorzugt 5 nm, besonders bevorzugt 10 nm, und/oder höchstens 50 nm, vorzugsweise höchstens 40 nm, besonders bevorzugt höchstens 30 nm auf. Eine kompakte Bauweise und dennoch zuverlässige Funktion kann erzielt werden.

In einer Ausführungsform umfasst oder besteht die Emitter-Basis-Tunnelbarriere 210 und/oder die Basis-Kollektor-Tunnelbarriere 214 aus einem Isolatorwerkstoff, der insbesondere eine Bandlücke von mindestens 0,4 eV aufweist, vorzugsweise MgO oder $AlO_x$, grundsätzlich aber auch $AlO_x$, MgAlO, $TaO_x$, $SiO_2$, $HfO_2$, intrinsische Halbleiter wie z.B. Si, GaAs, und zweidimensionale Systeme wie z.B. hexagonales BN. Ein Tunneltransistor mit besonders geringem Leckstrom kann so bereitgestellt werden.

Insbesondere weisen die Emitter-Basis-Tunnelbarriere 210 und/oder die Basis-Kollektor-Tunnelbarriere 214 eine Schichtdicke von mindestens 0,5 nm, bevorzugt 1 nm, und/oder höchstens 5 nm, vorzugsweise höchstens 4 nm, besonders bevorzugt höchstens 2 nm auf. Eine zuverlässige Barrierefunktion kann so ermöglicht werden, während zu dicke Schichtstärken zu stark den Tunneleffekt hindern und noch dünnere Schichtstärken im Elektrischen Feld zusammenbrechen können.

In einer Ausführungsform umfasst oder besteht die Halbleiterschicht ohne Spin-Anregungslücke 212 aus einem magnetischen Werkstoff, der insbesondere eine Magnetisierungsrichtung in Schichtebene oder unter einem Winkel zur Schichtebene aufweist. Grundsätzlich ist die Halbleiterschicht ohne Spin-Anregungslücke 212 so beschaffen, dass die Magnetisierungsrichtung des Halbleiters ohne Spin-Anregungslücke 112 in Anwesenheit eines Magnetfeldes konfiguriert und auch im Betrieb des Tunneltransistors rekonfiguriert werden kann. Eine Umstellung der Stromleitrichtung des Tunneltransistors im Betrieb kann so ermöglicht werden.

Vorzugsweise umfasst oder besteht die Halbleiterschicht ohne Spin-Anregungslücke 112 aus einer quartären Heusler'schen Legierungen (engl. quaternary Heusler compounds) wie z.B. FeCrXZ, FeVXZ', and MnVXZ" Verbindungen, wobei X= Ti, Zr oder Hf, Z=Al, Ga, In, B oder Tl, Z'=Si, Ge, Sn, C oder Pb, und Z"=P, As, Sb, N oder Bi ist. Grundsätzlich kommt auch für die Halbleiterschicht ohne Spin-Anregungslücke 212 jedes Material mit Halbleitereigenschaft ohne Spin-Anregungslücke vorzugsweise mit einer Curie-Temperatur oberhalb der Raumtemperatur in Betracht.

Insbesondere weist die Halbleiterschicht ohne Spin-Anregungslücke 212 einer Dicke von mindestens 1 nm, bevorzugt 2 nm, und/oder höchstens 40 nm, vorzugsweise höchstens 20 nm, besonders bevorzugt höchstens 8 nm auf. Ein zuverlässiges Rekonfigurieren kann so ermöglicht werden, wo hingegen bei dickeren Schichten zumindest ein strominduziertes Spin-Transfer-Drehmoment-Rekonfigurieren ggf. nicht mehr erzielt werden kann. Eine optimale Schichtdicke für die Halbleiterschicht ohne Spin-Anregungslücke 212 beträgt regelmäßig genau oder ungefähr 3 nm. Eine Herstellbarkeit der Halbleiterschicht ohne Spin-Anregungslücke 212 mit reproduzierbaren Eigenschaften und eine zuverlässige Funktion des Tunneltransistors kann so ermöglicht werden.

In einem ersten exemplarischen Ausführungsbeispiel umfasst ein erfindungsgemäßer magnetischer Tunneltransistor 200, der in Figur 6 schematisch dargestellt ist, eine Trägerschicht 202 aus MgO, eine Emitterelektrode 204 aus Ta mit 20 nm Schichtdicke, eine Emitter-Feststellschicht 206 aus IrMn mit 10 nm Schichtdicke, eine Emitter-Halbmetall-Magnetschicht 208 aus $Co_2MnSi$ mit 20 nm Schichtdicke, eine Emitter-Basis-Tunnelbarriere 210 aus MgO mit 1 nm Schichtdicke, eine Halbmetallschicht ohne Spin-Anregungslücke 212 aus FeVTiSi mit 2 nm Schichtdicke, eine Basis-Kollektor-Tunnelbarriere 214 aus MgO mit 1 nm Schichtdicke, eine Kollektor-Halbmetall-Magnetschicht 216 aus $Co_2MnSi$ mit 20 nm Schichtdicke, einer Kollektor-Feststellschicht 218 aus IrMn mit 10 nm Schichtdicke und/oder eine Kollektorelektrode 220 aus Ta mit 20 nm Schichtdicke. Der so aufgebaute magnetische Tunneltransistor 200 zeigte die Funktionen Nichtflüchtigkeit und Rekonfigurierbarkeit der Durchlassrichtung.

Ein Rekonfigurieren durch strominduziertes Umschalten der Magnetisierungsrichtung der Halbmetallschicht ohne Spin-Anregungslücke 212 aus FeVTiSi kann durch Anlegen eines Stroms zwischen Emitter und Basis ($I_B$) und/oder zwischen Kollektor und Basis ($I_E$) größer als dem Betriebsstrom in Höhe einer kritischen Stromdichte $I_{cr}$ von ungefähr $10^7$ $A/cm^2$ bewirkt werden (Fig. 6).

In einem zweiten exemplarischen Ausführungsbeispiel umfasst ein erfindungsgemäßer magnetischer Tunneltransistor 200, der in Figur 6 schematisch dargestellt ist, eine Trägerschicht 202 aus MgO, eine Emitterelektrode 204 aus Ta mit 20 nm Schichtdicke, eine Emitter-Feststellschicht 206 aus IrMn mit 10 nm Schichtdicke, eine Emitter-Halbmetall-Magnetschicht 208 aus $Co_2FeAl$ mit 30 nm Schichtdicke, eine Emitter-Basis-Tunnelbarriere 210 aus MgO mit 3 nm Schichtdicke, eine Halbmetallschicht ohne Spin-Anregungslücke 212 aus FeVZrSi mit 8 nm Schichtdicke, eine Basis-Kollektor-Tunnelbarriere 214 aus MgO mit 2 nm Schichtdicke, eine Kollektor-Halbmetall-Magnetschicht 216 aus $Co_2FeAl$ mit 30 nm Schichtdicke, einer Kollektor-Feststellschicht 218 aus IrMn mit 10 nm Schichtdicke und/oder eine Kollektorelektrode 220 aus Ta mit 20 nm Schichtdicke. Der so aufgebaute magnetische Tunneltransistor 200 zeigte die Funktionen Nichtflüchtigkeit und Rekonfigurierbarkeit der Durchlassrichtung.

In einem dritten exemplarischen Ausführungsbeispiel umfasst ein erfindungsgemäßer magnetischer Tunneltransistor 200, der in Figur 6 schematisch dargestellt ist, eine Trägerschicht 202 aus MgO, eine Emitterelektrode 204 aus Ta mit 20 nm Schichtdicke, eine Emitter-Feststellschicht 206 aus IrMn mit 10 nm Schichtdicke, eine Emitter-Halbmetall-Magnetschicht 208 aus $Co_2FeAl_{0,5}Si_{0,5}$ mit 10 nm Schichtdicke, eine Emitter-Basis-Tunnelbarriere 210 aus MgO mit 3 nm Schichtdicke, eine Halbmetallschicht ohne Spin-Anregungslücke 212 aus FeVZrGe mit 2 nm Schichtdicke, eine Basis-Kollektor-Tunnelbarriere 214 aus MgO mit 2 nm Schichtdicke, eine Kollektor-Halbmetall-Magnetschicht 216 aus $Co_2FeAl_{0,5}Si_{0,5}$ mit 10 nm Schichtdicke, einer Kollektor-Feststellschicht 218 aus IrMn mit 10 nm Schichtdicke und/oder eine Kollektorelektrode 220 aus Ta mit 20 nm Schichtdicke. Der so aufgebaute magnetische Tunneltransistor 200 zeigte die Funktionen Nichtflüchtigkeit und Rekonfigurierbarkeit der Durchlassrichtung.

Eine oder sämtliche Schichten des magnetischen Tunneltransistors 200 der Fig. 2 kann durch Abscheidungsverfahren oder Beschichtungstechniken wie z.B. Magnetron-Sputtern, Radiofrequenz-Sputtern und/oder Elektronenstrahlverdampfung hergestellt werden. Dabei können dieselben Herstellungsschritte zur Anwendung kommen, die oben für das erste exemplarische Ausführungsbeispiel der magnetischen Tunneldiode 100 beschrieben wurden.

In einer Ausführungsform besteht die Kollektor-Halbmetall-Magnetschicht 216 aus dem gleichen Material wie die Emitter-Halbmetall-Magnetschicht 208. Ein reduzierter Herstellungsaufwand für den Tunneltransistor kann so ermöglicht werden.

In einer Ausführungsform besteht die Basis-Kollektor-Tunnelbarriere 214 aus dem gleichen Material wie die Emitter-Basis-Tunnelbarriere 210. Ein reduzierter Herstellungsaufwand für den Tunneltransistor kann so ermöglicht werden.

In einer Ausführungsform besteht die eine Emitter-Feststellschicht 206 aus dem gleichen Material wie die Kollektor-Feststellschicht 218. Ein reduzierter Herstellungsaufwand für den Tunneltransistor kann so ermöglicht werden.

In einer Ausführungsform weist der magnetische Tunneltransistor 200 von der Basis-Kollektor-Tunnelbarriere 214 bis zur Emitter-Basis-Tunnelbarriere 210 im Querschnitt einen symmetrischen Aufbau insbesondere mit gleichen Schichtdicken der zwischen der Basis-Kollektor-Tunnelbarriere 214 und der Emitter-Basis-Tunnelbarriere 210 angeordneten Schichten auf. Eine besonders homogene Funktionsweise und Zuverlässigkeit kann so erreicht werden.

In einer Ausführungsform weisen die magnetischen Schichten 108, 208 und/oder 216 Schichtdicken von mindestens 1 nm und/oder höchstens 40 nm auf.

In einer Ausführungsform weisen die magnetischen Schichten 112 und/oder 212 Schichtdicken von mindestens 1 nm und/oder höchstens 40 nm auf.

In einer Ausführungsform weist der magnetische Tunneltransistor 200 von der Kollektor-Halbmetall-Magnetschicht 216 bis zur Emitter-Halbmetall-Magnetschicht im Querschnitt einen symmetrischen Aufbau insbesondere mit gleichen Schichtdicken der zwischen der Kollektor-Halbmetall-Magnetschicht 216 und der Emitter-Halbmetall-Magnetschicht angeordneten Schichten auf. Eine besonders homogene Funktionsweise und Zuverlässigkeit kann so erreicht werden.

In einer Ausführungsform weist der magnetische Tunneltransistor 200 von der Emitter-Feststellschicht 206 bis zur Kollektor-Feststellschicht 218 im Querschnitt einen symmetrischen Aufbau insbesondere mit gleichen Schichtdicken der zwischen der Emitter-Feststellschicht 206 und der Kollektor-Feststellschicht 218 angeordneten Schichten auf. Eine besonders homogene Funktionsweise und Zuverlässigkeit kann so erreicht werden.

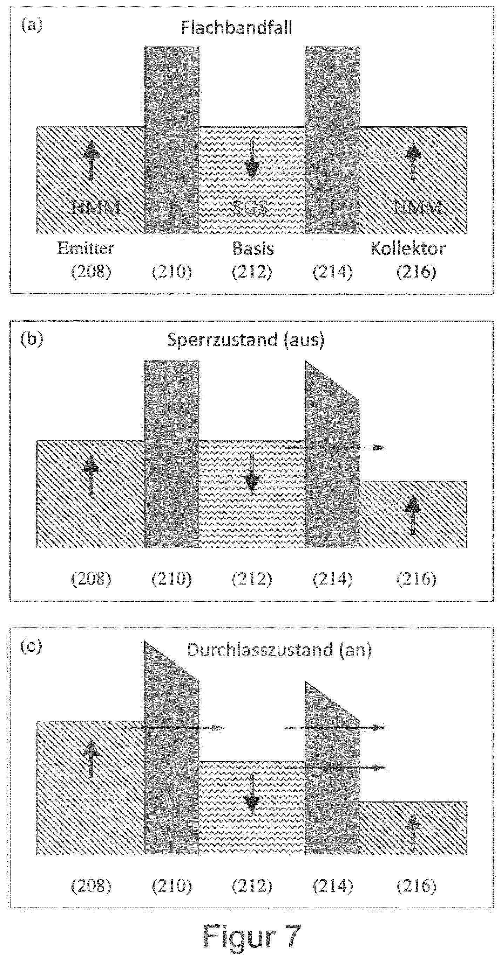

Figur 7 zeigt ein schematisches Energiebanddiagramm des rekonfigurierbaren magnetischen Tunneltransistors 200 in verschiedenen Betriebszuständen. Die Magnetisierungsrichtung des Emitter-Halbmetall-Magnetschicht 208 und des Kollektor-Halbmetall-Magnetschicht 216 sind parallel ausgerichtet und die Halbmetallschicht ohne Spin-Anregungslücke 212 weist eine demgegenüber umgekehrte Magnetisierungsrichtung auf, wie die Pfeile in Fig. 7a bis 7c zeigen.

Ohne Spannungsabfall über der Emitter-Basis-Tunnelbarriere 210, also $V_{BE}$=0, befindet sich der Transistor im Sperrzustand, unabhängig davon, ob eine positive Vorspannung an der Kollektorelektrode 220 anliegt. Im Sperrzustand fließt kein oder zumindest ein nur vernachlässigbar geringer Strom vom Emitter, also der Emitter-Halbmetall-Magnetschicht 208, zum Kollektor, also der Kollektor-Halbmetall-Magnetschicht 216. Zudem verhindert die oben beschriebene besondere Bandstruktur der Halbleiterschicht ohne Spin-Anregungslücke 212 das Fließen eines Basis-Kollektor-Leckstroms.

Dies bietet einen besonderen Vorteil gegenüber konventionellen Hot-Carrier-Tunneltransistoren, bei denen zur Verringerung eines Stromflusses vom Emitter zum Kollektor dicke Basis-Kollektor-Tunnelbarrieren verwendet werden, welche jedoch zu kleinen Transferraten α führen.

Bei der in Figur 6 dargestellten magnetischen Tunneldiode 200 ist der Effekt zu beobachten, dass wenn eine endliche positive Sperrspannung über die Basiselektrode 213 an die Halbleiterschicht ohne Spin-Anregungslücke 212 und an über die Kollektorelektrode 220 an die Kollektor-Halbmetall-Magnetschicht 216 angelegt wird ($V_{CB} > 0$), heiße Elektronen mit hoher kinetischer Energie vom Emitter zur Basis, also der Halbleiterschicht ohne Spin-Anregungslücke 212, fließen können, indem sie durch die isolierende Emitter-Basis-Tunnelbarriere 210 tunneln. Die fließenden heißen Elektronen durchqueren die Basiszone bzw. die Halbleiterschicht ohne Spin-Anregungslücke 212, wobei manche der Elektronen ihre hohe Energie behalten und den Kollektor erreichen. So kann der Zustand des rekonfigurierbaren magnetischen Tunneltransistors durch Anlegen einer Spannung an die Basiselektrode 213 gesteuert werden.

Ein besonderer Vorteil des erfindungsgemäßen magnetischen Tunneltransistors 200 liegt darin, dass dieser in beiden Richtungen Strom leiten kann, ähnlich wie bei konventionellen MOSFETs. Konventionelle Hot-Carrier-Tunneltransistoren können keinen Strom in beide Richtungen leiten.

Die Figur 8b veranschaulicht den Mechanismus, welcher bei dem erfindungsgemäßen magnetischen Tunneltransistor 200 Leckströme, also ein Elektronenfluss von der Basis zum Kollektor, zu verhindern oder zumindest auf ein vernachlässigbares Maß reduzieren kann. Bei dem in Fig. 8b dargestellten Zustand des Transistors ist eine endlichen Vorspannung ($V_{CB} > 0$) an die Kollektorelektrode 220 angelegt, was in der Regel im Betrieb ununterbrochen der Fall ist. Dadurch, dass an dem Kollektor keine Spannung anliegt ($V_{BE} = 0$), befindet sich der magnetische Tunneltransistor 200 im Sperrzustand. Das Vorliegen des Sperrzustands ohne oder nahezu ohne einen Elektronenfluss zum Kollektor liegt darin begründet, dass in der Kollektor-Halbmetall-Magnetschicht 216 für Minoritäts-Spin-Elektronen keine Zustände oberhalb der Fermienergie vorhanden sind und damit ein Elektronentunneln heißer Elektronen, also energetisch angeregte Elektronen, des unterhalb der Fermienergie besetzen Minoritäts-Spin-Valenzbandes der Basis trotz der Spannung $V_{CB} > 0$ zum Kollektor verhindert oder zumindest entgegengewirkt werden kann.

Die Spin-Anregungslücke $G_{VB}$ (siehe Fig. 1) des Kollektors, also der Abstand zwischen Fermienergie und Minoritäts-Spin-Valenzband, legt die maximale Kollektor-Spannung fest, bei der der Basis-Kollektor-Leckstrom verhindert oder nahezu verhindert werden kann. Insbesondere liegt bei den vorliegend verwendeten halbmetallischen Magnetwerkstoffen der Emitter-Halbmetall-Magnetschicht 208 und/oder der Kollektor-Halbmetall-Magnetschicht 216 dieser Wert unter 1 eV. Einem Elektronentunneln von der Basis zum Kollektor kann dadurch besonders erfolgreich entgegengewirkt werden.

Die Figur 8c veranschaulicht nun den Mechanismus, welcher einen Elektronenfluss von dem Emitter zum Kollektor ermöglicht, und zwar über die Basis, d.h. mit vorübergehendem Aufenthalt in der Basis bzw. einem Durchqueren der Basis. Wenn an die Basiselektrode 213 eine positive Vorspannung ($V_{BE} > 0$) angelegt wird und ebenfalls eine positive Vorspannung ($V_{CB} > 0$) an der Kollektorelektrode 220 anliegt - was grundsätzlich der Regelfall ist -, können heiße Elektronen vom Emitter durch die isolierende Emitter-Basis-Tunnelbarriere 210 zur Basis tunneln, da die Elektronenstruktur des HMM-I-SGS-Tunnelkontakts 160 des magnetischen Tunneltransistors 200 - also Emitter-Halbmetall-Magnetschicht 208, Emitter-Basis-Tunnelbarriere 210 und Halbleiterschicht ohne Spin-Anregungslücke 212 - diesen Tunnelprozess zulässt. Denn heiße Elektronen des besetzten Majoritäts-Spin-Bandes des Emitters unterhalb der Fermienergie links von der Vertikalachse können zum unbesetzten Majoritäts-Spin-Band der Basis oberhalb der Fermienergie links von der Vertikalachse wandern.

Ein Teil dieser auf diese Weise in die Basiszone gelangten heißen Elektronen kann danach je nach ihrer Energie gleich weiter zum Kollektor tunneln und die Basis-Kollektor-Tunnelbarriere 214 überwinden, da auch hier der HMM-I-SGS-Tunnelkontakts 160 des magnetischen Tunneltransistors 200 - also Halbleiterschicht ohne Spin-Anregungslücke 212, Basis-Kollektor-Tunnelbarriere 214, Kollektor-Halbmetall-Magnetschicht 216 - diesen Tunnelprozess zulässt. Denn das Majoritäts-Spin-Band des Kollektors oberhalb der Fermienergie und links der Vertikalachse ist unbesetzt. Manche dieser Elektronen werden in der Basis thermalisiert und erzeugen den Basisstrom $I_B$. Der Emitterstrom $I_E$ ergibt sich aus der Summe von Basisstrom und Kollektorstrom: $I_E = I_B + I_C$.

Wie oben anhand der Figur 8b beschrieben können Elektronen des besetzten Minoritäts-Spin-Bandes unterhalb der Fermienergie auf der rechten Seite der Vertikalachse jedoch nach wie vor nicht oder nahezu nicht von der Basis zum Kollektor wandern oder tunneln, weil der Kollektor gar kein erreichbares Minoritäts-Spin-Band auf der rechten Seite von der Vertikalachse im Bereich der Fermienergie aufweist. Schließlich liegt dort die Bandlücke $G_{VB}$, $G_{CB}$ vor.

Dadurch kann bei dem erfindungsgemäßen magnetischen Tunneltransistor 200 sowie der erfindungsgemäßen magnetischen Tunneldiode 100 ermöglicht werden, dass die Dicke und Höhe der Tunnelbarrieren 210, 216 bzw. der Tunnelbarriere 110 so klein wie möglich gewählt werden kann, um die Leistung der Bauelemente zu erhöhen, da der Tunnelstrom mit abnehmender Barriere-Dicke und -Höhe exponentiell steigt.

Der erfindungsgemäße magnetische Tunneltransistor 200 kann wie die erfindungsgemäße magnetische Tunneldiode 100 durch Umschalten der Magnetisierungsrichtung der Halbleiterschicht ohne Spin-Anregungslücke 212 konfiguriert werden.

Dies kann entweder durch Anlegen eines externen Magnetfelds oder durch einen strominduzierten Spin-Transfer-Drehmoment-Mechanismus - auch strominduziertes magnetisches Umschalten genannt - erreicht werden. Dazu wird ein Strom mit einer Stromstärke größer als der Betriebsstromstärke angelegt.

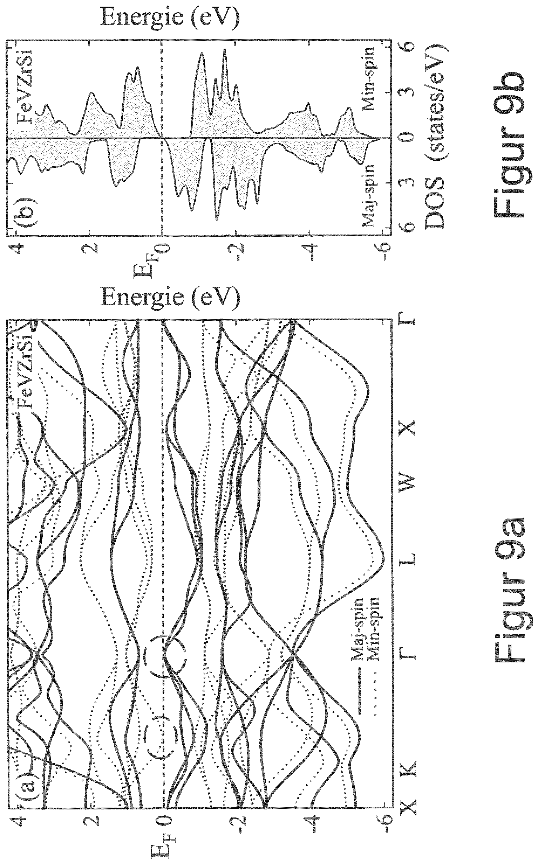

Figur 9a zeigt die nach Spin aufgelöste Elektronenbandstruktur der Halbleiterschicht ohne Spin-Anregungslücke 212 aus einer FeVZrSi-Legierung entlang der hochsymmetrischen Linien in der Brillouin-Zone. Die durchgezogenen Linien zeigen die Bandstruktur der Majoritäts-Spin-Elektronen.

Die gestrichelten Linien zeigen die Bandstruktur der Minoritäts-Spin-Elektronen. Die Werte auf der Vertikalachse sind so angegeben, dass die Fermienergie bei 0 eV liegt und als gestrichelt Horizontale eingezeichnet ist. Wie in Fig. 9a erkennbar, grenzt das Valenzband der Majoritäts-Spin-Elektronen am Γ-Punkt an die Fermienergie (markiert durch einen Kreis).

Das niedrigste Leitungsband der Minoritäts-Spin-Elektronen grenzt an einem Punkt zwischen K- und Γ-Punkt an die Fermienergie (ebenfalls markiert durch einen Kreis). Folglich besitzen das Valenzband der Majoritäts-Spin-Elektronen und das Leitungsband der Minoritäts-Spin-Elektronen keine indirekte Spin-Anregungslücke. Die Auswertung der FeVZrSi-Legierung verifizierte somit das Vorliegen eines Halbleiters ohne Spin-Anregungslücke und wurde daher in dem zweiten Ausführungsbeispiel einer erfindungsgemäßen magnetischen Tunneldiode als Halbleiter ohne Spin-Anregungslücke 112 sowie in dem zweiten Ausführungsbeispiel eines erfindungsgemäßen magnetischen Tunneltransistors als Halbleiterschicht ohne Spin-Anregungslücke 212 verwendet.

Figur 9b veranschaulicht durch die DOS-Darstellung analog zu Figur 1 das Vorliegen eines Halbleiters ohne Spin-Anregungslücke. Das Majoritäts-Spin-Band auf der linken Seite der Vertikalachse unterhalb der als gestrichelte Horizontale eingezeichneten Fermienergie grenzt an dem Schnittpunkt der Vertikalachse mit der Fermienergie an das auf der rechten Seite der Vertikalachse liegende Minoritätsband oberhalb der Fermienergie an.

Das nach Spin aufgelöste Zustandsdichte-Diagramm (DOS) der Fig. 9b wurde aus dem Integral über alle K-Punkte in der gesamten Brillouin-Zone in einem bestimmten Energiebereich (hier: -6 eV to 4 eV) der Figur 9a berechnet. Die Bandstruktur und Zustandsdichte in Figur 9a und 9b wurden unter Verwendung der Dichtefunktionaltheorie innerhalb der generalisierten Gradienten-Näherung für das Austauschkorrelations-Funktional mit einem dichten K-Punkt-Gitter von $20 \times 20 \times 20$ ermittelt.

Zu den konkreten Anwendungsmöglichkeiten für die erfindungsgemäße Tunneldiode und den erfindungsgemäßen Tunneltransistor zählen ein magnetischer Feldsensor, ein Speicherelement z.B. in einem STT-MRAM, Baustein mit Logikgatter bzw. Spin-Logik-Gatter und ein Schalter

Insbesondere umfasst die Materialschicht aus dem Halbleiter ohne Spin-Anregungslücke 112 FeCrXZ, FeVXZ' und/oder MnVXZ", wobei X=Ti, Zr oder Hf, Z=B, Al, Ga oder In, Z'=C, Si, Ge, Sn und Z"=N, P, As oder Sb sind. Insbesondere betrifft dies die magnetische Tunneldiode 100 und/oder den magnetischen Tunneltransistor 200.

Der halbmetallische Magnet 108 und der Halbleiter ohne Spin-Anregungslücke 112 der magnetischen Tunneldiode (Fig. 2) und/oder des magnetischen Tunneltransistors (Fig. 6) müssen nicht zwangläufig die in den obigen Beispielen angegebenen, dreidimensionalen Stoffe oder Stoffgemische aufweisen. Es gibt eine Reihe von atomar dünne zweidimensionale Materialien, welche halbmetallische Magneteigenschaften aufweisen, also halbmetallisch magnetisch sind, und/oder Halbleitereigenschaften ohne Spin-Anregungslücke aufweisen, also ein Halbleiter ohne Spin-Anregungslücke sind. Beispiele dafür, insbesondere Stoffe mit Halbleitereigenschaften ohne Spin-Anregungslücke, sind hydriertes Graphen (engl. hydrogenated graphene), $VX_2$ und/oder $NbX_2$ (X=O, S, Se, Te). Die Dicke dieser insbesondere zweidimensionalen halbmetallischen Magneten und/oder Halbleiter ohne Spin-Anregungslücke ist insbesondere mindestens 0,1 nm oder mindestens 1 nm, und/oder höchstens 2 nm.

Insbesondere umfasst die magnetische Tunneldiode 100 und/oder der magnetischen Tunneltransistor 200 eine Schichtdicke der Materialschicht aus dem halbmetallischen Magneten (108) von mindestens 0,1 nm.

Insbesondere umfasst die magnetische Tunneldiode 100 und/oder der magnetischen Tunneltransistor 200 eine Schichtdicke der Materialschicht aus dem Halbleiter ohne Spin-Anregungslücke (112) von mindestens 0,1 nm.

Insbesondere umfasst die Materialschicht aus dem Halbleiter ohne Spin-Anregungslücke (112) ein Material oder besteht daraus, das eine Dicke von nur einer Atomlage aufweist, im Wesentlichen zweidimensional ist, also eine zweidimensionale Struktur aufweist, und/oder atomar dünn ist. Insbesondere betrifft dies die magnetische Tunneldiode 100 und/oder den magnetischen Tunneltransistor 200.

Insbesondere umfasst die Materialschicht aus dem Halbleiter ohne Spin-Anregungslücke (112) hydriertes Graphen, $VX_2$ und/oder $NbX_2$ oder besteht daraus, wobei X = O, S, Se, Te ist.

Bei dem Aspekt der Erfindung betreffend das Verfahren zum Konfigurieren und/oder Rekonfigurieren der Stromdurchlassrichtung der magnetischen Tunneldiode und/oder des magnetischen Tunneltransistors, wobei zum Umkehren der Magnetisierungsrichtung des Halbleiters ohne Spin-Anregungslücke der Tunneldiode, des halbmetallischen Magneten der Tunneldiode und/oder der Halbleiterschicht ohne Spin-Anregungslücke des Tunneltransistors Strom mit einer Stromstärke größer als der Betriebsstromstärke angelegt oder ein externes Magnetfeld aktiviert wird, kann die Betriebsstromstärke wie folgt ermittelt werden:

Betriebsstromstärke ist gleich der Stromdichte multipliziert mit der Querschnittsfläche der Diode oder des Transistors. Die Betriebsstrom stärke kann mit "I" symbolisiert werden.

Querschnittsfläche meint die Fläche, die sich orthogonal zur Stromfließrichtung erstreckt. Stromfließrichtung ist die Richtung des Stroms zum Konfigurieren und/oder Rekonfigurieren der Stromdurchlassrichtung der magnetischen Tunneldiode und/oder des magnetischen Tunneltransistors. In den Figuren 2 und 6 ist die Stromfließrichtung vertikal und die Querschnittsfläche erstreckt sich horizontal und in Blickrichtung.

Insbesondere wird die Querschnittsfläche durch das Produkt aus Länge und Breite definiert, wobei die Länge und/oder Breite mindestens 5 nm, bevorzugt mindestens 50 nm, und/oder höchstens 200 nm, bevorzugt höchstens 150 nm, beträgt.

Insbesondere beträgt die Länge und Breite 100 nm und die Querschnittsfläche somit 10000 nm, vorzugsweise bei einem Tunnelübergang.

Die Stromdichte ist insbesondere mindestens $10^7$ A/cm$^2$.

In einer Ausführungsform beträgt die Betriebsstromstärke $10^7$ A/cm$^2$ x 100 nm x 100 nm = $10^{-3}$ A

## Patentansprüche

1. Magnetische Tunneldiode (100) mit zwei Anschlüssen (104, 114) zum Verbinden mit einem Stromkreis sowie einem Tunnelkontakt (160) mit einer Materialschicht aus einem halbmetallischen Magneten (108), einer Tunnelbarriere (110) und einer Materialschicht aus einem Halbleiter (112), **dadurch gekennzeichnet, dass** der Halbleiter keine Spin-Anregungslücke aufweist.

2. Magnetische Tunneldiode (100) nach Anspruch 1, **dadurch gekennzeichnet, dass** die Materialschicht aus dem halbmetallischen Magneten (108) eine fixierte Magnetisierungsrichtung und die Materialschicht aus dem Halbleiter ohne Spin-Anregungslücke (112) eine rekonfigurierbare Magnetisierungsrichtung aufweist, oder umgekehrt.

3. Magnetische Tunneldiode (100) nach einem der vorhergehenden Ansprüche, **gekennzeichnet durch** eine an den Tunnelkontakt (160) angrenzende Feststellschicht (106) zum Fixieren der Magnetisierungsrichtung entweder der Materialschicht aus dem halbmetallischen Magneten (108) oder der Materialschicht aus dem Halbleiter ohne Spin-Anregungslücke (112).

4. Magnetische Tunneldiode (100) nach einem der vorhergehenden Ansprüche, **gekennzeichnet durch** eine Schichtdicke der Materialschicht aus dem halbmetallischen Magneten (108) von mindestens 0,1 nm oder 1 nm, bevorzugt 5 nm, besonders bevorzugt 10 nm, und/oder höchstens 50 nm, vorzugsweise höchstens 40 nm, besonders bevorzugt höchstens 30 nm.

5. Magnetische Tunneldiode (100) nach einem der vorhergehenden Ansprüche, **gekennzeichnet durch** eine Schichtdicke der Materialschicht aus dem Halbleiter ohne Spin-Anregungslücke (112) von mindestens 0,1 nm oder 1 nm, bevorzugt 2 nm, und/oder höchstens 40 nm, vorzugsweise höchstens 20 nm, besonders bevorzugt höchstens 8 nm.

6. Magnetische Tunneldiode (100) nach einem der vorhergehenden Ansprüche, **dadurch gekennzeichnet, dass** die Materialschicht aus dem Halbleiter ohne Spin-Anregungslücke (112) FeCrXZ, FeVXZ' und/oder MnVXZ" umfasst, wobei X=Ti, Zr oder Hf, Z=B, Al, Ga oder In, Z'=C, Si, Ge, Sn und Z"=N, P, As oder Sb sind.

7. Magnetische Tunneldiode (100) nach einem der vorhergehenden Ansprüche, **dadurch gekennzeichnet, dass** die Materialschicht aus dem Halbleiter ohne Spin-Anregungslücke (112) FeVTiSi, FeVZrSi und/oder FeVZrGe umfasst.

8. Magnetische Tunneldiode (100) nach einem der vorhergehenden Ansprüche, **dadurch gekennzeichnet, dass** die Materialschicht aus dem Halbleiter ohne Spin-Anregungslücke (112) Material mit einer Dicke von nur einer Atomlage umfasst oder daraus besteht.

9. Magnetische Tunneldiode (100) nach einem der vorhergehenden Ansprüche, **dadurch gekennzeichnet, dass** die Materialschicht aus dem Halbleiter ohne Spin-Anregungslücke (112) hydriertes Graphen, $VX_2$ und/oder $NbX_2$ umfasst oder daraus besteht, wobei X = O, S, Se, Te ist.

10. Magnetischer Tunneltransistor (200) mit drei Anschlüssen (204, 213, 220) zum Verbinden mit einem Stromkreis sowie einer Schichtanordnung, insbesondere umfassend den Tunnelkontakt (160) der magnetischen Tunneldiode (100) nach einem der vorhergehenden Ansprüche, umfassend eine Emitter-Halbmetall-Magnetschicht (208), eine Emitter-Basis-Tunnelbarriere (210), eine Halbleiterschicht (212), eine Basis-Kollektor-Tunnelbarriere (214) und eine Kollektor-Halbmetall-Magnetschicht (216), **dadurch gekennzeichnet, dass** die Halbleiterschicht keine Spin-Anregungslücke aufweist.

11. Magnetischer Tunneltransistor (200) nach dem vorhergehenden Anspruch, **dadurch gekennzeichnet, dass** die Schichtanordnung genau die im vorhergehenden Anspruch genannte Schichtreihenfolge aufweist.

12. Verfahren zum Konfigurieren und/oder Rekonfigurieren einer Stromdurchlassrichtung der magnetischen Tunneldiode (100) nach einem der vorhergehenden Ansprüche 1-9 und/oder des magnetischen Tunneltransistors (200) nach einem der vorhergehenden Ansprüche 10 oder 11, wobei zum Umkehren der Magnetisierungsrichtung des Halbleiters ohne Spin-Anregungslücke (112), des halbmetallischen Magneten (108) und/oder der Halbleiterschicht ohne Spin-Anregungslücke (212) ein Strom mit einer Stromstärke größer als der Betriebsstromstärke angelegt oder ein externes Magnetfeld aktiviert wird.

13. Verwendung einer Halbleiterschicht ohne Spin-Anregungslücke (112, 212) in einer magnetischen Tunneldiode (100), insbesondere nach einem der vorhergehenden Ansprüche 1-9, oder in einem magnetischen Tunneltransistor (200), insbesondere nach einem der vorhergehenden Ansprüche 10 oder 11, zur Erzielung der Eigenschaften Nichtflüchtigkeit und/oder Rekonfigurierbarkeit einer Stromdurchlassrichtung.

14. Verwendung einer Halbleiterschicht ohne Spin-Anregungslücke (112, 212) in einer magnetischen Tunneldiode (100), insbesondere nach einem der vorhergehenden Ansprüche 1-9, oder in einem magnetischen Tunneltransistor (200), insbesondere nach einem der vorhergehenden 10 oder 11, zur Erzielung eines inversen Tunnelmagnetowiderstand-Effekts, wobei der magnetische Tunnelwiderstand das Vorzeichen wechselt, wenn die Polarität der angelegten Vorspannung wechselt.

15. Verwendung nach dem vorhergehenden Anspruch, **dadurch gekennzeichnet, dass** die Materialschicht aus dem halbmetallischen Magneten (108) der magnetischen Tunneldiode (100), die Emitter-Halbmetall-Magnetschicht (208) oder die Kollektor-Halbmetall-Magnetschicht (216) des magnetischen Tunneltransistors (200) aus einem ferromagnetischen oder ferrimagnetischen Material sind.

**Claims**

1. A magnetic tunnel diode (100) having two connections (104, 114) for the connection with an electric circuit as well as a tunnel contact (160) comprising a material layer made of a semi-metallic magnet (108), a tunnel barrier (110) and a material layer made of a semi-conductor (112), **characterized in that** the semi-conductor does not comprise any spin excitation gap.

2. A magnetic tunnel diode (100) according to claim 1, **characterized in that** the material layer made of the semi-metallic magnet (108) comprises a fixed magnetisation direction and the material layer made of the semi-conductor without spin excitation gap (112) comprises a reconfigurable magnetisation direction or vice versa.

3. A magnetic tunnel diode (100) according to one of the preceding claims, **characterized by** a fixation layer (106) adjacent to the tunnel contact (160) for fixing the magnetisation direction of either the material layer made of the semi-metallic magnet (108) or the material layer of the semi-conductor without spin excitation gap (112).

4. A magnetic tunnel diode (100) according to one of the preceding claims, **characterized by** a layer thickness of the material layer made of the semi-metallic magnet (108) of at least 0.1 nm or 1 nm, preferably 5 nm, more preferably 10 nm and/or at most 50 nm, preferably at most 40 nm, more preferably at most 30 nm.

5. A magnetic tunnel diode (100) according to one of the preceding claims, **characterized by** a layer thickness of the material layer made of the semi-conductor without spin excitation gap (112) of at least 0.1 nm or 1 nm, preferably 2 nm and/or at most 40 nm, preferably at most 20 nm, more preferably at most 8 nm.

6. A magnetic tunnel diode (100) according to one of the preceding claims, **characterized in that** the material layer made of the semi-conductor without spin excitation gap (112) comprises FeCrXZ, FeVXZ' and/or MnVXZ", wherein X = Ti, Zr or Hf, Z = B, Al, Ga or In, Z' = C, Si, Ge, Sn and Z" = N, P, As or Sb.

7. A magnetic tunnel diode (100) according to one of the preceding claims, **characterized in that** the material layer made of the semi-conductor without spin excitation gap (112) comprises FeVTiSi, FeVZrSi and/or FeVZrGe.

8. A magnetic tunnel diode (100) according to one of the preceding claims, **characterized in that** the material layer made of the semi-conductor without spin excitation gap (112) comprises material having a thickness of only one atomic layer or is composed thereof.

9. A magnetic tunnel diode (100) according to one of the preceding claims, **characterized in that** the material layer made of the semi-conductor without spin excitation gap (112) comprises hydrogenated graphene, $VX_2$ and/or $NbX_2$ or is composed thereof, wherein X = O, S, Se, Te.

10. A magnetic tunnel transistor (200) having three connections (204, 213, 220) for the connection with an electric circuit as well as a layer structure, in particular comprising the tunnel contact (160) of the magnetic tunnel diode (100) according to one of the preceding claims, comprising an emitter semi-metallic magnet layer (208), an emitter base tunnel barrier (210), a semi-conductor layer (212), a base collector tunnel barrier (214) and a collector semi-metallic magnetic layer (216), **characterized in that** the semi-conductor layer does not comprise any spin excitation gap.

11. A magnetic tunnel transistor (200) according to the preceding claim, **characterized in that** the layer structure exactly comprises the order of layers mentioned in the preceding claim.

12. A method for configuring and/or reconfiguring a current passage direction of the magnetic tunnel diode (100) according to one of the preceding claims 1-9 and/or the magnetic tunnel transistor (200) according to one of the preceding claims 10 or 11,
wherein for inverting the magnetisation direction of the semi-conductor without spin excitation gap (112) of the semi-metallic magnet (108) and/or the semi-conductor layer without spin excitation gap (212), a current having a strength that is higher than the operational current strength will be applied or an external magnetic field will be activated.

**13.** A use of a semi-conductor layer without spin excitation gap (112, 212) in a magnetic tunnel diode (100) in particular according to one of the preceding claims 1-9
or
in a magnetic tunnel transistor (200) in particular according to one of the preceding claims 10 or 11,
for obtaining the properties of non-volatility and/or reconfigurability of a current passage direction.

**14.** A use of a semi-conductor layer without spin excitation gap (112, 212) in a magnetic tunnel diode (100) in particular according to one of the preceding claims 1-9
or
in a magnetic tunnel transistor (200) in particular according to one of the preceding claims 10 or 11,
for obtaining an inverse tunnel magneto-resistor effect, wherein the magnetic tunnel resistance changes the sign, if the polarity of the applied pretension changes.

**15.** A use according to the preceding claim, **characterized in that** the material layer made of the semi-metallic magnet (108) of the magnetic tunnel diode (100), the emitter semi-metallic magnet layer (208) or the collector semi-metallic magnetic layer (216) of the magnetic tunnel transistor (200) are made of a ferromagnetic or ferrimagnetic material.

**Revendications**

**1.** Diode à effet tunnel magnétique (100) ayant deux connexions (104, 114) pour le raccordement à un circuit électrique, ainsi qu'un contact tunnel (160) comprenant une couche de matière composée d'un aimant semi-métallique (108), une barrière de tunnel (110) et une couche de matière composée d'un semi-conducteur (112), **caractérisée en ce que** le semi-conducteur ne comprend pas de lacune d'excitation de spin.

**2.** Diode à effet tunnel magnétique (100) selon la revendication 1, **caractérisée en ce que** la couche de matière composée de l'aimant semi-métallique (108) comprend une direction de magnétisation fixée et la couche de matière composée du semi-conducteur sans lacune d'excitation de spin (112) comprend une direction de magnétisation reconfigurable ou vice versa.

**3.** Diode à effet tunnel magnétique (100) selon l'une des revendications précédentes, **caractérisée par** une couche de fixation (106) adjacente au contact tunnel (160) pour fixer la direction de magnétisation soit de la couche de matière composée de l'aimant semi-métallique (108) soit de la couche de matière composée du semi-conducteur sans lacune d'excitation de spin (112).

**4.** Diode à effet tunnel magnétique (100) selon l'une des revendications précédentes, **caractérisée par** une épaisseur de couche de la couche de matière composée de l'aimant semi-métallique (108) d'au moins 0,1 nm ou de 1 nm, de préférence de 5 nm, de préférence particulière de 10 nm et/ou d'au plus 50 nm, de préférence d'au plus 40 nm et de préférence particulière d'au plus 30 nm.

**5.** Diode à effet tunnel magnétique (100) selon l'une des revendications précédentes, **caractérisée par** une épaisseur de couche de la couche de matière composée du semi-conducteur sans lacune d'excitation de spin (112) d'au moins 0,1 nm ou de 1 nm, de préférence de 2 nm, et/ou d'au plus 40 nm, de préférence d'au plus 20 nm et de préférence particulière d'au plus 8 nm.

**6.** Diode à effet tunnel magnétique (100) selon l'une des revendications précédentes, **caractérisée en ce que** la couche de matière composée du semi-conducteur sans lacune d'excitation de spin (112) comprend du FeCrXZ, du FeVXZ' et/ou du MnVXZ", dans lequel X = Ti, Zr ou Hf, Z = B, Al, Ga ou In, Z' = C, Si, Ge, Sn et Z" = N, P, As ou Sb.

**7.** Diode à effet tunnel magnétique (100) selon l'une des revendications précédentes, **caractérisée en ce que** la couche de matière composée du semi-conducteur sans lacune d'excitation de spin (112) comprend du FeVTiSi, du FeVZrSi et/ou du FeVZrGe.

**8.** Diode à effet tunnel magnétique (100) selon l'une des revendications précédentes, **caractérisée en ce que** la couche de matière composée du semi-conducteur sans lacune d'excitation de spin (112) comprend du matériau comprenant une épaisseur d'une seule couche d'atomes ou elle est composée de celui-ci.

**9.** Diode à effet tunnel magnétique (100) selon l'une des revendications précédentes, **caractérisée en ce que** la couche de matière composée du semi-conducteur sans lacune d'excitation de spin (112) comprend du graphène hydrogéné, du $VX_2$ et/ou du $NbX_2$ ou elle est composée de ceux-ci, dans lequel X = O, S, Se, Te.

10. Transistor à effet tunnel magnétique (200) ayant trois connexions (204, 213, 220) pour le raccordement à un circuit électrique, ainsi qu'une disposition à couches, notamment comprenant le contact tunnel (160) de la diode à effet tunnel magnétique (100) selon l'une des revendications précédentes, comprenant une couche magnétique semi-métallique d'émetteur (208), une barrière de tunnel de base d'émetteur (210), une couche de semi-conducteur (212), une barrière de tunnel de collecteur de base (214) et une couche magnétique semi-métallique de collecteur (216), **caractérisé en ce que** la couche de semi-conducteur ne comprend pas de lacune d'excitation de spin.

11. Transistor à effet tunnel magnétique (200) selon la revendication précédente, **caractérisé en ce que** la disposition à couches comprend exactement l'ordre de couches décrit dans la revendication précédente.

12. Procédé de configuration et/ou de reconfiguration d'une direction de passage de courant de la diode à effet tunnel magnétique (100) selon l'une des revendications précédentes 1 à 9
et/ou
du transistor à effet tunnel magnétique (200) selon l'une des revendications précédentes 10 ou 11,
dans lequel un courant ayant une intensité supérieure à celle du courant de fonctionnement est appliqué ou un champ magnétique externe est activé pour inverser la direction de magnétisation du semi-conducteur sans lacune d'excitation de spin (112) de l'aimant semi-métallique (108) et/ou de la couche de semi-conducteur sans lacune d'excitation de spin (212).

13. Utilisation d'une couche de semi-conducteur sans lacune d'excitation de spin (112, 212) dans une diode à effet tunnel magnétique (100) notamment selon l'une des revendications précédentes 1 à 9
ou
dans un transistor à effet tunnel magnétique (200) notamment selon l'une des revendications précédentes 10 ou 11,
pour obtenir les propriétés de non-volatilité et/ou de reconfigurabilité d'une direction de passage de courant.

14. Utilisation d'une couche de semi-conducteur sans lacune d'excitation de spin (112, 212) dans une diode à effet tunnel magnétique (100) notamment selon l'une des revendications précédentes 1 à 9
ou
dans un transistor à effet tunnel magnétique (200) notamment selon l'une des revendications précédentes 10 ou 11,
pour obtenir un effet de magnétorésistance à effet tunnel inverse, dans lequel la résistance de tunnel magnétique changera le signe algébrique, si la polarité de la tension de polarisation appliquée change.

15. Utilisation selon la revendication précédente, **caractérisée en ce que** la couche de matière composée de l'aimant semi-métallique (108) de la diode à effet tunnel magnétique (100), la couche magnétique semi-métallique d'émetteur (208) ou la couche magnétique semi-métallique de collecteur (216) du transistor à effet tunnel magnétique (200) sont composées d'un matériau ferromagnétique ou d'un matériau ferrimagnétique.

Figur 1a

Figur 1b

Figur 2

Figur 3a

Figur 3b

EP 3 371 836 B1

Figur 4

Figur 5

Figur 6

(a) Flachbandfall

HMM    I    SCS    I    HMM

Emitter    Basis    Kollektor
(208)    (210)    (212)    (214)    (216)

(b) Sperrzustand (aus)

(208)    (210)    (212)    (214)    (216)

(c) Durchlasszustand (an)

(208)    (210)    (212)    (214)    (216)

Figur 7

Figur 8

Figur 9a

Figur 9b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 8269293 B2
- US 7259437 B2
- US 8233249 B2
- US 20040207961 A1
- EP 1548832 A1
- US 2008246023 A1
- US 20110042712 A1

**In der Beschreibung aufgeführte Nicht-Patentliteratur**

- **T. NAGAHAMA et al.** *Appl. Phys. Lett.,* 2010, vol. 96, 112509
- **H. YAN et al.** *Nature,* 2011, vol. 470, 240